(19) Europäisches Patentamt
European Patent Office
Office européen des brevets

(11) EP 3 077 475 B1

(12) **EUROPEAN PATENT SPECIFICATION**

(45) Date of publication and mention of the grant of the patent:
**04.07.2018 Bulletin 2018/27**

(21) Application number: **14799670.6**

(22) Date of filing: **11.11.2014**

(51) Int Cl.:
***C09K 11/02*** *(2006.01)* ***C09K 11/06*** *(2006.01)*
***C09D 11/52*** *(2014.01)* ***H01L 51/50*** *(2006.01)*

(86) International application number:
**PCT/EP2014/003015**

(87) International publication number:
**WO 2015/082037 (11.06.2015 Gazette 2015/23)**

(54) **COMPOSITIONS CONTAINING A POLYMERIC BINDER WHICH COMPRISES ACRYLIC AND/OR METHACRYLIC ACID ESTER UNITS**

ZUSAMMENSETZUNGEN MIT EINEM POLYMEREN BINDEMITTEL MIT ACRYL- UND/ODER METHACRYLSÄUREESTEREINHEITEN

COMPOSITIONS CONTENANT UN LIANT POLYMÈRE QUI COMPREND DES UNITÉS D'ESTER D'ACIDE ACRYLIQUE ET/OU MÉTHACRYLIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.12.2013 EP 13005696**

(43) Date of publication of application:
**12.10.2016 Bulletin 2016/41**

(73) Proprietor: **Merck Patent GmbH**
**64293 Darmstadt (DE)**

(72) Inventors:
- **PAN, Junyou**
**60320 Frankfurt am Main (DE)**
- **LUDEMANN, Aurélie**
**60322 Frankfurt am Main (DE)**
- **LEONHARD, Christoph**
**64853 Otzberg (DE)**
- **MAY, Philip Edward**
**Sidcup DA15 9AS (GB)**

(56) References cited:
**WO-A1-2012/132863**
**US-A1- 2008 258 111**
**US-A1- 2012 273 736**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 077 475 B1

## Description

Field of the Invention

The present invention relates to novel compositions comprising organic light emitting materials and charge transporting materials and a polymeric binder which comprises 100 mol% acrylic and/or methacrylic acid ester units, to their use as inks for the preparation of organic light emitting diode (OLED) devices, to methods for preparing OLED devices using the novel compositions, and to OLED devices prepared from such methods and compositions.

Background and Prior Art

When preparing OLED devices usually printing techniques like inkjet printing, roll to roll printing, slot dye coating, flexographic printing or gravure printing are used to apply the active layer. Based on low solubility of the most of the organic compounds useful as emitting materials and/or charge transport materials, these techniques need the use of solvents in high amounts.

In order to improve the film forming ability binding agents can be used. These additives are especially needed with respect to light emitting materials and/or charge transport materials having small molecular weight or polymeric compounds having a low molecular weight.

EP 1 883 124 A1 describes a formulation of light-emitting materials particularly suitable for forming displays and lamps via printing techniques comprising an organic-light emitting material housed in protective porous matrix material, a binder and a solvent. However, the OLED material encompasses also polymeric materials. Furthermore, the binder material is disclosed as a long list without any detailed specification.

US 2007/0103059 A1 discloses compositions comprising an OLED material and a polymer having very specific repeating units. The polymer having specific repeating units is added to improve the emitting efficiency of the OLED. Also polymeric OLED materials can be employed.

According to US 6,818,919 B1 and US 7,115,430 B1 polymers having a high glass transition temperature $T_g$ have to be used in order to process low molecular weight organic light emitting and charge transporting materials. However, these materials are expensive and limit the application of the compositions.

US 5,952,778 B1 relates to an encapsulated organic light emitting device having an improved protective covering comprising a first layer of a passivating metal, a second layer of an inorganic dielectric material and a third layer of a polymer. The organic light emitting material can be polymeric or monomeric. The composition can contain a polymer binder. However, the binder material is disclosed in a long list without any detailed specification.

US 6,277,504 B1 discloses specific light emitting compounds and compositions comprising the same. The compositions may include a binder. However, no detailed specification of the binder is provided.

US 6,294,273 B1 describes light emitting compounds being soluble in methanol. The compositions comprising these compounds may contain polymer binders. However, the binder material is disclosed in a long list without any detailed specification.

WO 2005/055248 A2 relates to compositions comprising specific organic semiconductor compounds and an organic binder having a permittivity of 3.3 or less at 1000 Hz. However, the specific organic semiconductor compounds as disclosed in WO 2005/055248 A2 should form a layer having a high crystallinity in order to achieve a high efficiency. In contrast thereto, layers emitting light should usually have a low crystallinity for providing high efficiency. Therefore, the concept of WO 2005/055248 A2 cannot be applied to OLED layers.

US 2012/0273736 A1 discloses a composition comprising one or more organic light emitting materials and/or charge transport materials having a molecular weight of at most 5000 g/mol, one or more organic solvents, and one or more polymers, wherein said polymer is an inert binder.

Solutions of small molecules in a solvent do not generally have a big effect on the viscosity of the resultant solution as occurs with polymers. Therefore, compositions of small molecules for conventional printing applications like ink jet printing, flexographic or gravure printing need additives to increase ink viscosity and improve film formation. The prior art provides compositions being useful in order to process low molecular weight organic light emitting and charge transport materials. However, it is a permanent desire to improve the performance of the OLED layer, especially in terms of efficiency, lifetime and sensitivity regarding oxidation and/or water.

It is therefore desirable to have fluids comprising light emitting materials and/or charge transport materials that are suitable for the preparation of OLED devices by the aforementioned solution based processes, which allow the manufacture of very homogeneous OLED devices having a high efficiency, a long lifetime, and a low sensitivity against water and/or oxidation. One aim of the present invention is to provide such improved fluids. Another aim is to provide improved methods of preparing an OLED device from such fluids. Another aim is to provide improved OLED devices obtained from such fluids and methods. Further aims are immediately evident to the person skilled in the art from the following description.

Surprisingly it has been found that these aims can be achieved, and the above-mentioned problems can be solved, by providing methods, materials and devices as claimed in the present invention, especially by providing a process for preparing an OLED device using a composition containing a polymeric binder which comprises acrylic and/or methacrylic acid ester units.

## Summary of the Invention

The present invention relates to a composition comprising one or more organic light emitting materials and charge transporting materials having a molecular weight of at most 5000 g/mol, one or more organic solvents, and one or more polymers, characterized in that said polymer comprises 100 mol% acrylic and/or methacrylic acid ester units and in that said polymer has a weight average molecular weight $M_w$ in the range from 750,000 to 3,000,000 g/mol.

The present invention further relates to the use of a composition, often also named as formulation, as described above and below as coating or printing ink for the preparation of OLED devices, in particular for rigid and flexible OLED devices.

The present invention further relates to an OLED device prepared from a composition and/or by a process as described above and below.

OLED devices can for example be used for illumination, for medical illumination purposes, as signalling device, as signage devices, and in displays. Displays can be addressed using passive matrix driving, total matrix addressing or active matrix driving. Transparent OLEDs can be manufactured by using optically transparent electrodes. Flexible OLEDs are assessable through the use of flexible substrates.

The compositions and devices of the present invention provide surprising improvements in the efficiency of the OLED devices and the production thereof. Unexpectedly, the performance, the lifetime and the efficiency of the OLED devices can be improved, if these devices are achieved by using a composition of the present invention. Furthermore, the composition of the present invention provides an astonishingly high level of film forming. Especially, the homogeneity and the quality of the films can be improved. In addition thereto, the present invention enables better solution printing of multi layer devices.

## Detailed Description of the Invention

The organic light emitting materials and charge transporting materials can be selected from standard materials known to the skilled person and described in the literature having a molecular weight of at most 5000 g/mol. Preferably, the compostion comprises an organic light emitting material. Organic light emitting material according to the present application means a material which emits light having a $\lambda_{max}$ in the range from 300 to 800 nm.

The composition according to the present invention comprises preferably between 0.01 and 20% by weight, more preferably between 0.2 and 10% by weight and most preferably between 0.25 and 5% by weight, of the organic light emitting materials and/or charge transporting materials or the corresponding blend. The percent data relate to 100% of the solvent or solvent mixture.

The light emitting material and the charge transporting material (below together named as organic semiconductor) used here is a mixture of two or more components. The organic light emitting materials and charge transporting materials preferably include phosphorescent compounds.

Suitable phosphorescent compounds are, in particular, compounds which emit light, preferably in the visible region, on suitable excitation and in addition contain at least one atom having an atomic number greater than 20, preferably greater than 38 and less than 84, more preferably greater than 56 and less than 80. The phosphorescence emitters used are preferably compounds which contain copper, molybdenum, tungsten, rhenium, ruthenium, osmium, rhodium, iridium, palladium, platinum, silver, gold or europium, in particular compounds which contain iridium or platinum.

Particularly preferred organic phosphorescent compounds are compounds of formulae (1) to (4):

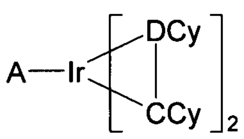

formula (1)

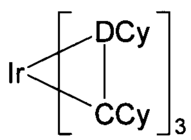

formula (2)

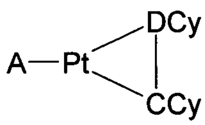

formula (3)

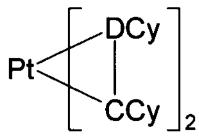

formula (4)

where

DCy is, identically or differently on each occurrence, a cyclic group which contains at least one donor atom, preferably nitrogen, carbon in the form of a carbene or phosphorus, via which the cyclic group is bonded to the metal, and which may in turn carry one or more substituents $R^1$; the groups DCy and CCy are connected to one another via a covalent bond;

CCy is, identically or differently on each occurrence, a cyclic group which contains a carbon atom via which the cyclic group is bonded to the metal and which may in turn carry one or more substituents $R^1$;

A is, identically or differently on each occurrence, a monoanionic, bidentate chelating ligand, preferably a diketonate ligand;

$R^1$ are, identically or differently at each instance, and are F, Cl, Br, I, $NO_2$, CN, a straight-chain, branched or cyclic alkyl or alkoxy group having from 1 to 20 carbon atoms, in which one or more non-adjacent $CH_2$ groups may be replaced by -O-, -S-, $-NR^2-$, $-CONR^2-$, -CO-O-, -C=O-, -CH=CH- or -C≡C-, and in which one or more hydrogen atoms may be replaced by F, or an aryl or heteroaryl group which has from 4 to 14 carbon atoms and may be substituted by one or more nonaromatic $R^1$ radicals, and a plurality of substituents $R^1$, either on the same ring or on the two different rings, may together in turn form a mono- or polycyclic, aliphatic or aromatic ring system; and

$R^2$ are, identically or differently at each instance, and are a straight-chain, branched or cyclic alkyl or alkoxy group having from 1 to 20 carbon atoms, in which one or more nonadjacent $CH_2$ groups may be replaced by -O-, -S-, -CO-O-, -C=O-, -CH=CH- or -C≡C-, and in which one or more hydrogen atoms may be replaced by F, or an aryl or heteroaryl group which has from 4 to 14 carbon atoms and may be substituted by one or more nonaromatic $R^1$ radicals.

Formation of ring systems between a plurality of radicals $R^1$ means that a bridge may also be present between the groups DCy and CCy. Furthermore, formation of ring systems between a plurality of radicals $R^1$ means that a bridge may also be present between two or three ligands CCy-DCy or between one or two ligands CCy-DCy and the ligand A, giving a polydentate or polypodal ligand system.

Examples of the emitters described above are revealed by the applications WO 00/70655, WO 01/41512, WO 02/02714, WO 02/15645, EP 1191613, EP 1191612, EP 1191614, WO 04/081017, WO 05/033244, WO 05/042550, WO 05/113563, WO 06/008069, WO 06/061182, WO 06/081973 and DE 102008027005. In general, all phosphorescent complexes as are used in accordance with the prior art for phosphorescent OLEDs and as are known to the person skilled in the art in the area of organic electroluminescence are suitable, and the person skilled in the art will be able to use further phosphorescent compounds without inventive step. In particular, it is known to the person skilled in the art which phosphorescent complexes emit with which emission colour.

Examples of preferred phosphorescent compounds are shown in the following table.

| | |
|---|---|
| 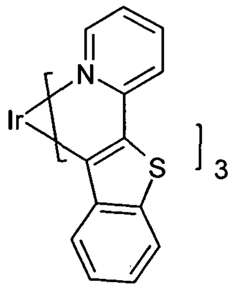 | 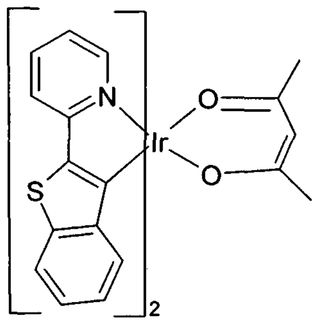 |

(continued)

| (1) | (2) |
|---|---|
| 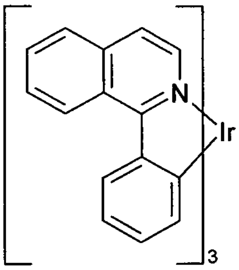 | 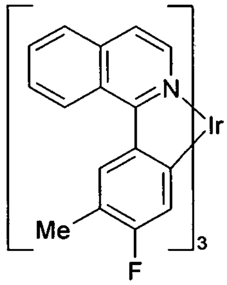 |
| (3) | (4) |
| 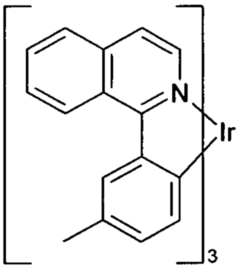 | 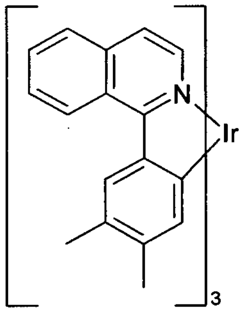 |
| (5) | (6) |
| 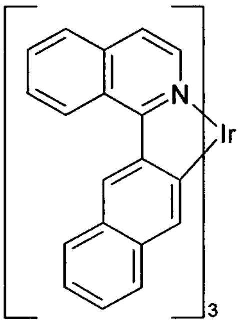 | 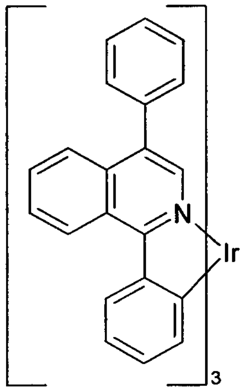 |
| (7) | (8) |
| 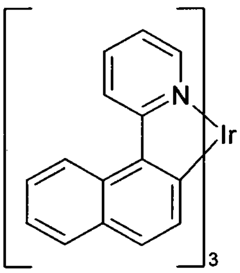 | 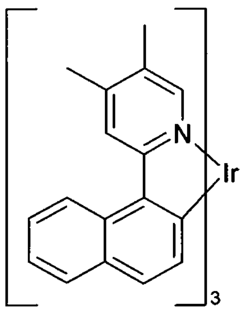 |
| (9) | (10) |

(continued)

| | |
|---|---|
| 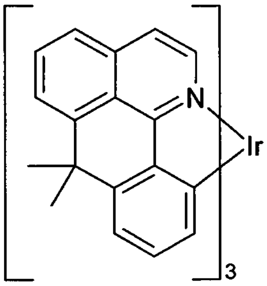 | 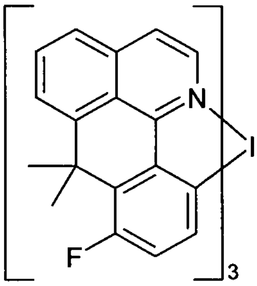 |
| (11) | (12) |
| 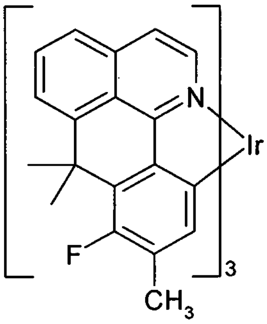 | 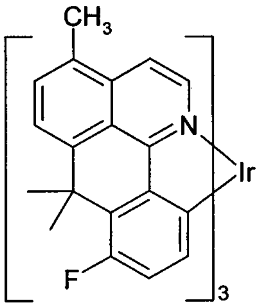 |
| (13) | (14) |
| 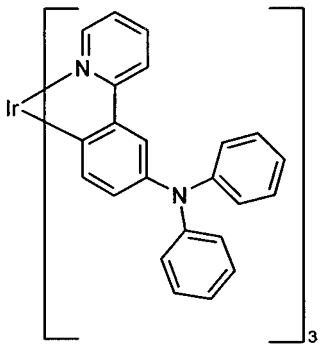 | 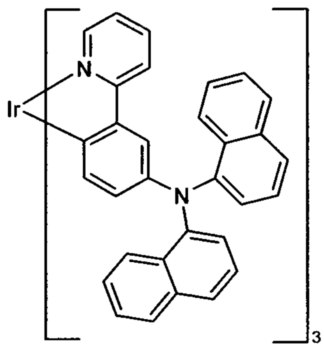 |
| (15) | (16) |
| 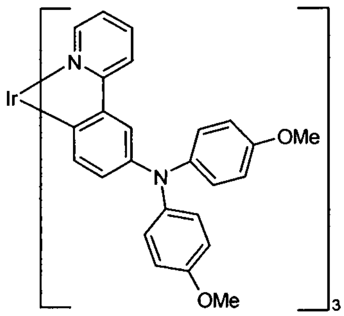 | 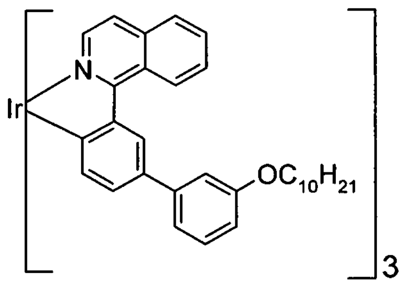 |
| (17) | (18) |

(continued)

| | |
|---|---|
| 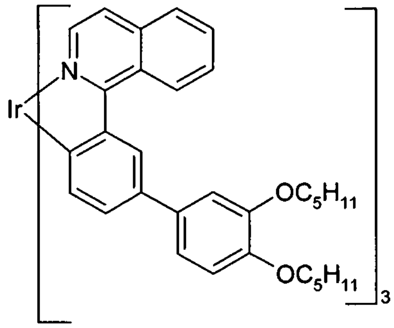 | 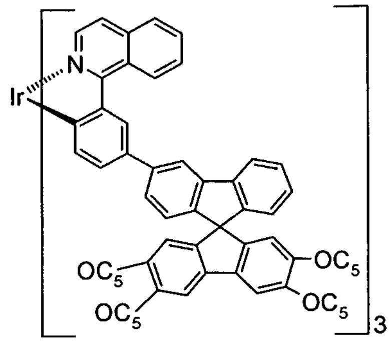 |
| (19) | (20) |
| 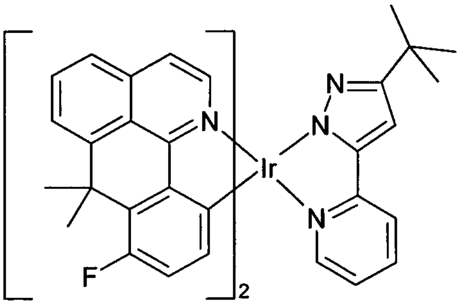 | 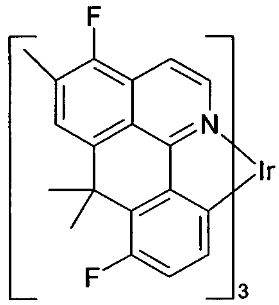 |
| (21) | (22) |
| 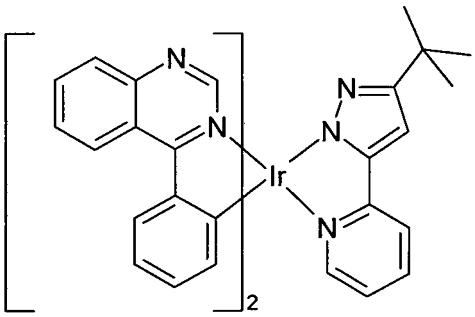 | 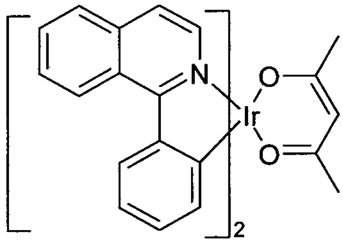 |
| (23) | (24) |
| 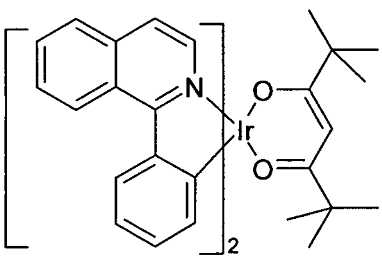 | 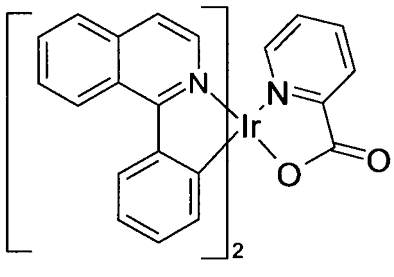 |
| (25) | (26) |

(continued)

| | |
|---|---|
| 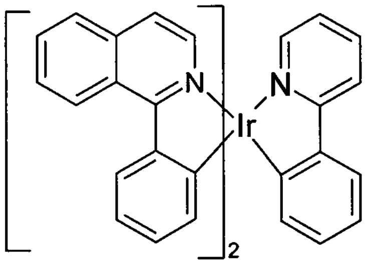 | 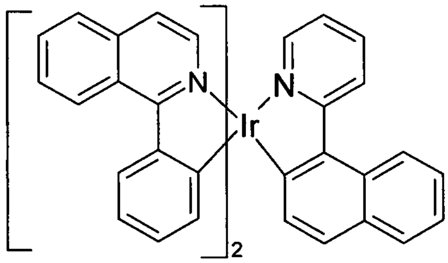 |
| (27) | (28) |
| 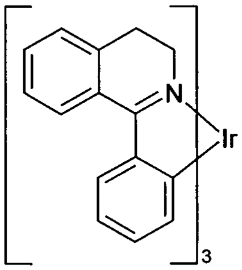 | 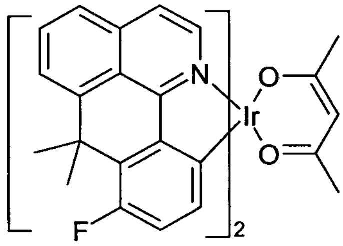 |
| (29) | (30) |
| 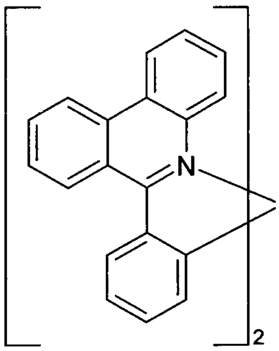 | 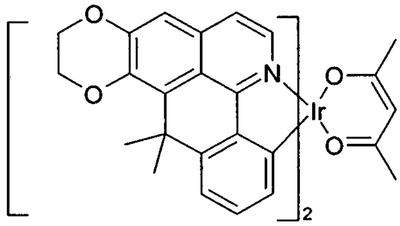 |
| (31) | (32) |
| 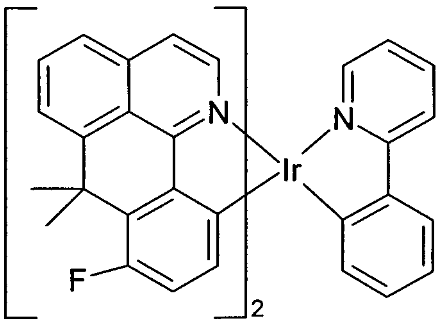 | 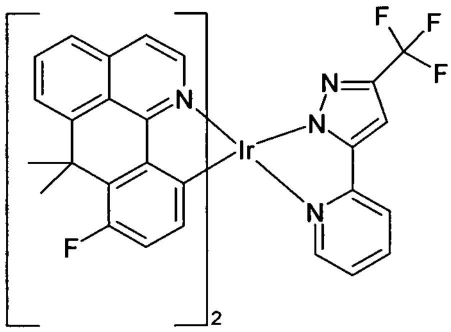 |
| (33) | (34) |

(continued)

| | |
|---|---|
| 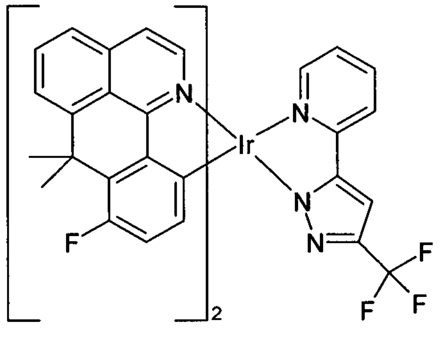 | 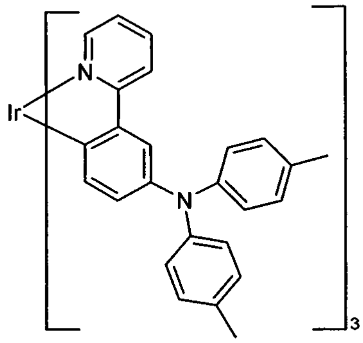 |
| (35) | (36) |
| 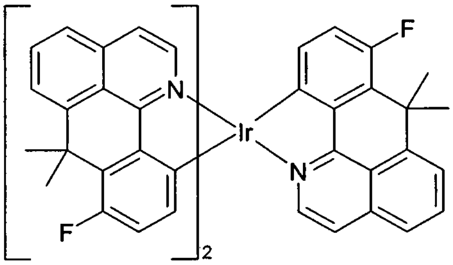 | 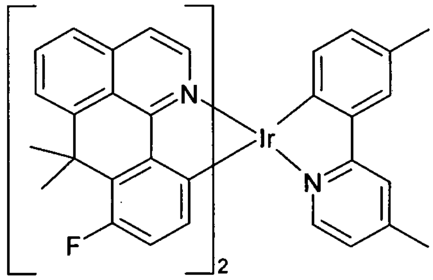 |
| (37) | (38) |
| 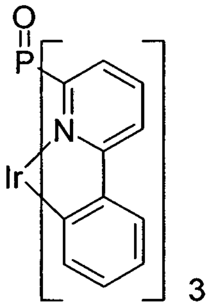 | 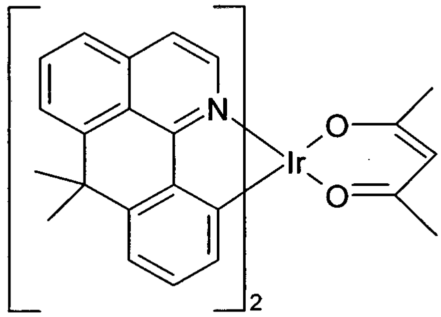 |
| (39) | (40) |
| 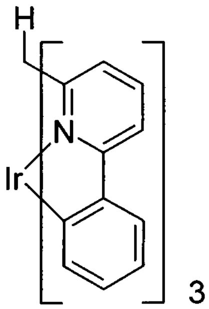 | 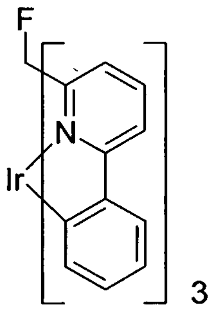 |
| (41) | (42) |

(continued)

| | |
|---|---|
| 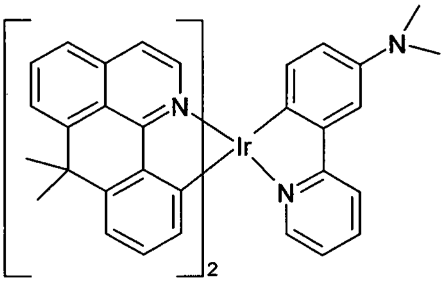 | 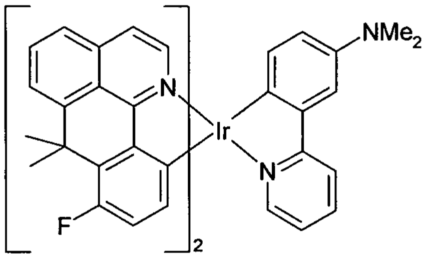 |
| (43) | (44) |
| 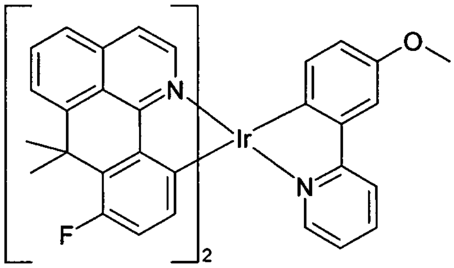 | 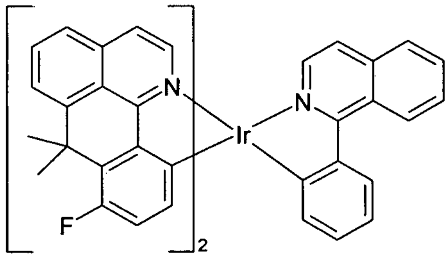 |
| (45) | (46) |
| 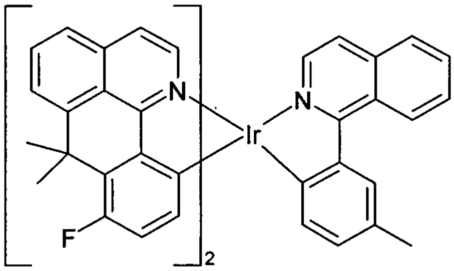 | 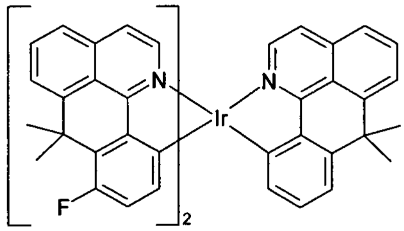 |
| (47) | (48) |

(continued)

| | |
|---|---|
| 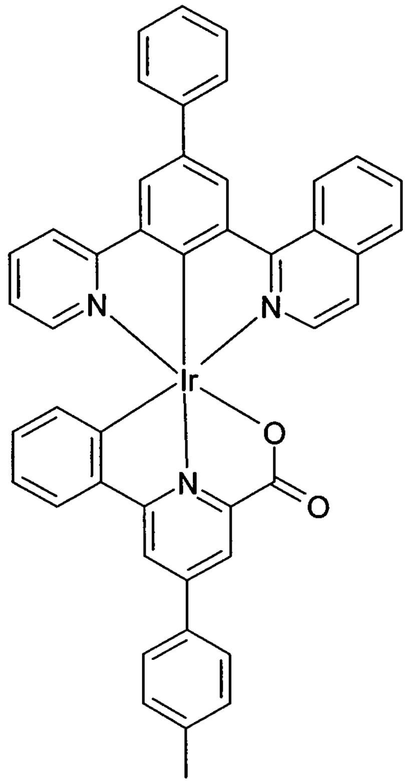 | 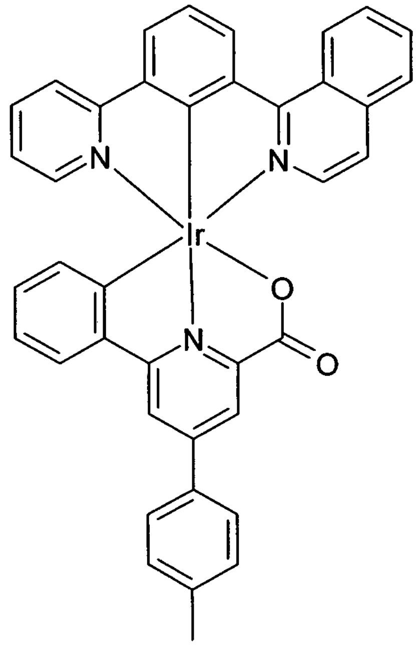 |
| (49) | (50) |
| 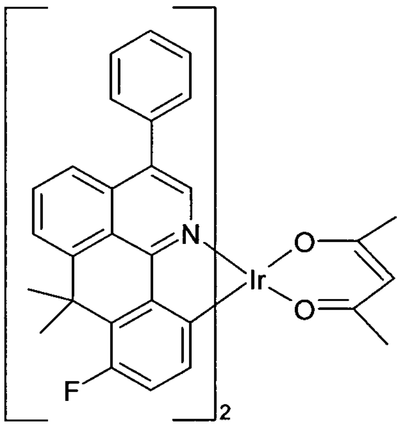 | 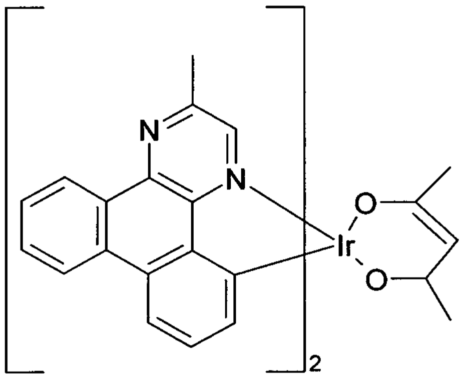 |
| (51) | (52) |
| 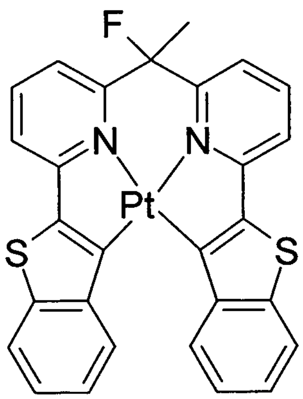 | 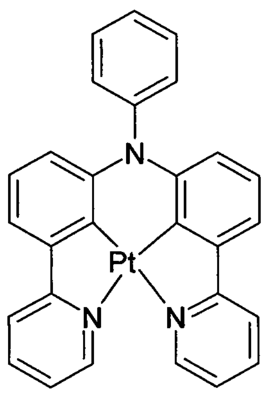 |

(continued)

| (53) | (54) |
|---|---|
| 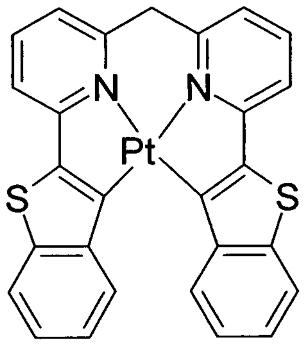 | 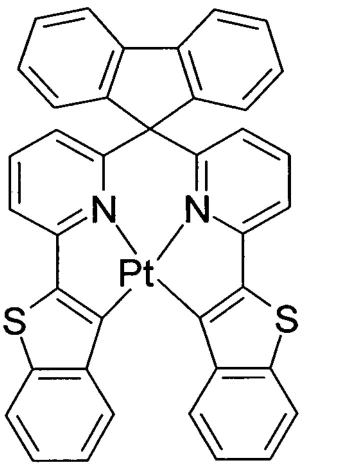 |
| (55) | (56) |
| 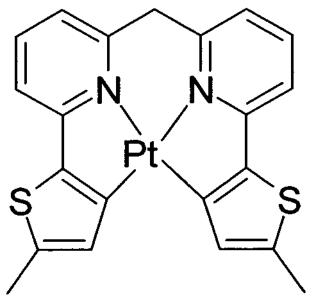 | 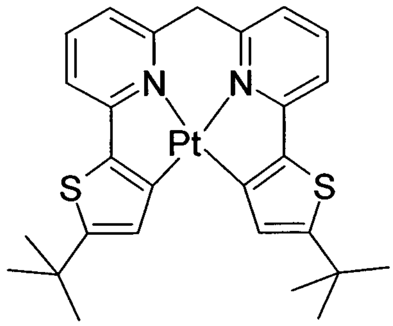 |
| (57) | (58) |
| 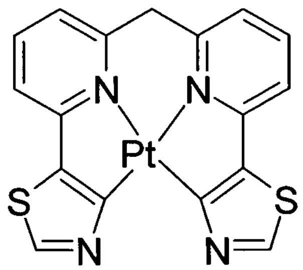 | 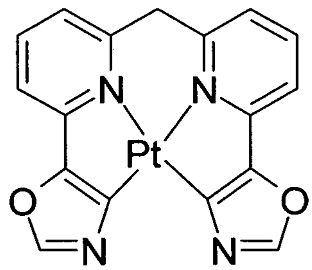 |
| (59) | (60) |
| 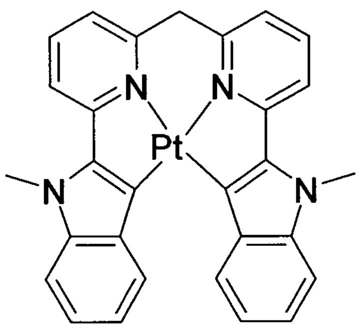 | 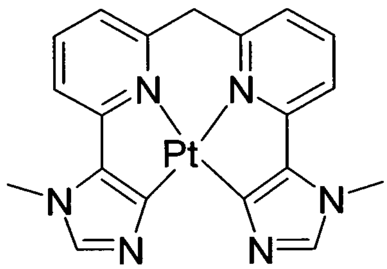 |
| (61) | (62) |

(continued)

| | |
|---|---|
| 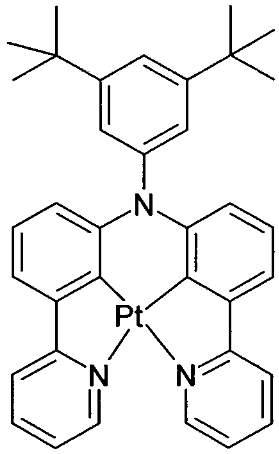 | 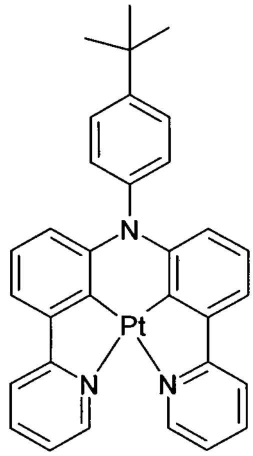 |
| (63) | (64) |
| 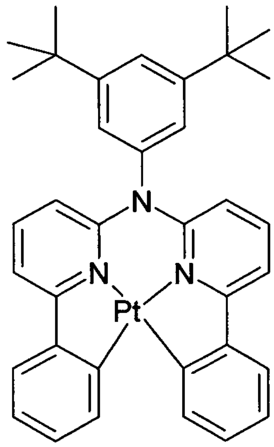 | 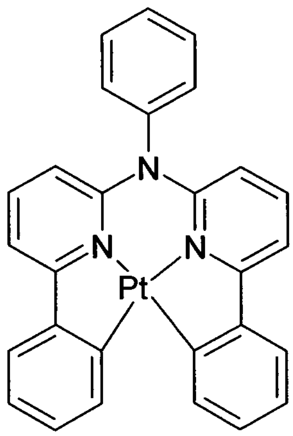 |
| (65) | (66) |
| 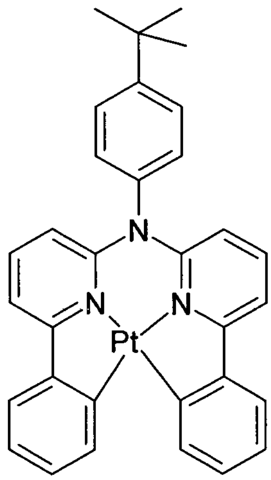 | 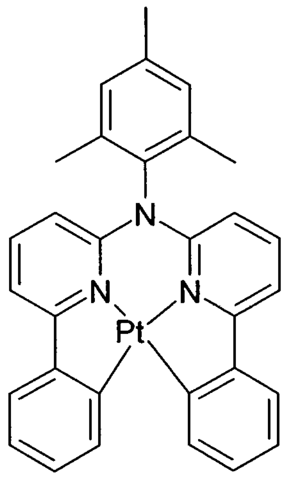 |
| (67) | (68) |

(continued)

| | |
|---|---|
| 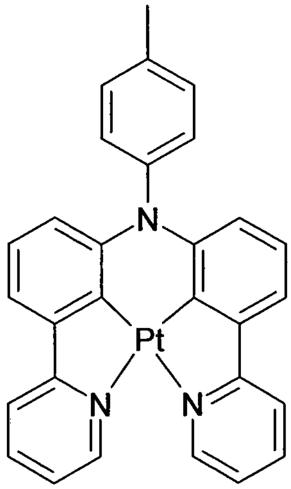 | 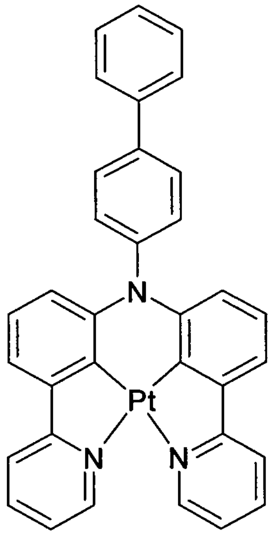 |
| (69) | (70) |
| 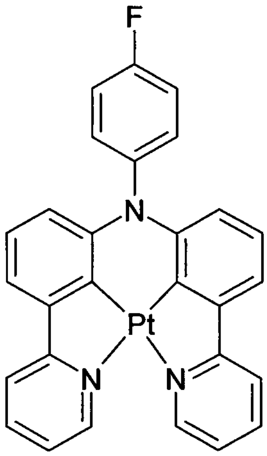 | 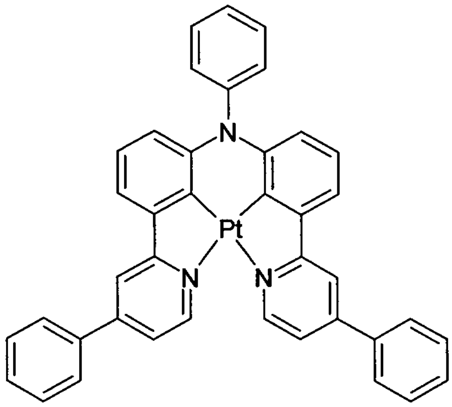 |
| (71) | (72) |
| 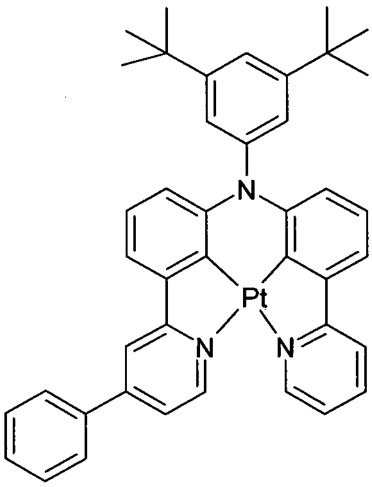 | 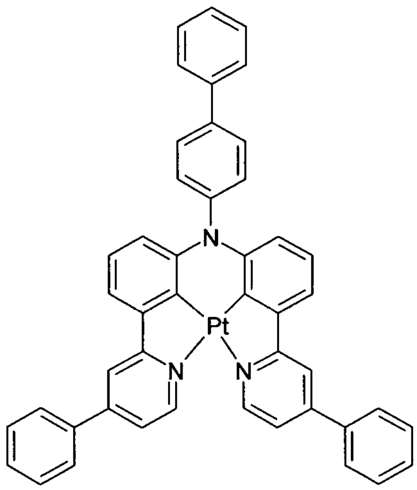 |
| (73) | (74) |

(continued)

| | |
|---|---|
| 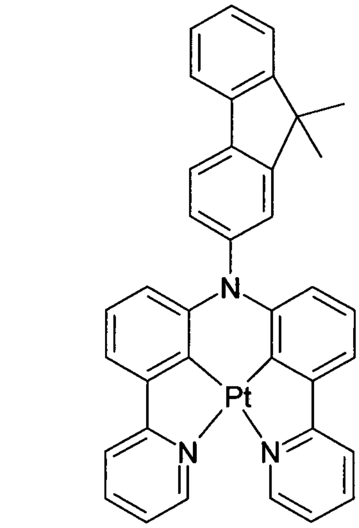 | 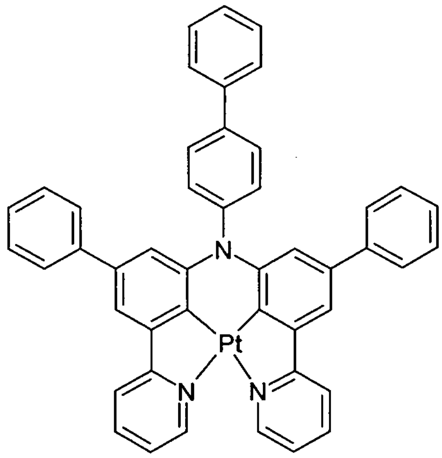 |
| (75) | (76) |
| 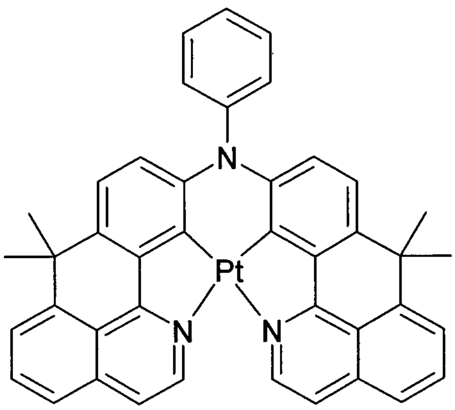 | 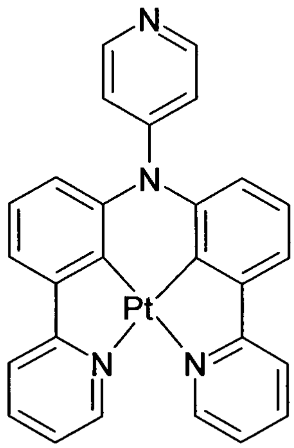 |
| (77) | (78) |
| 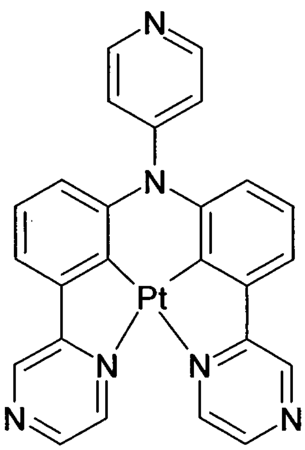 | 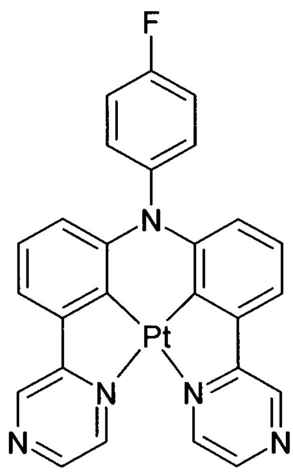 |
| (79) | (80) |

(continued)

| | |
|---|---|
| 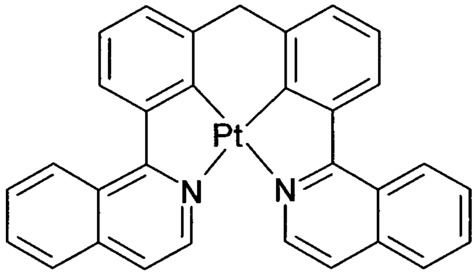 | 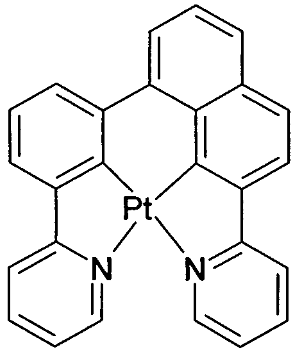 |
| (81) | (82) |
| 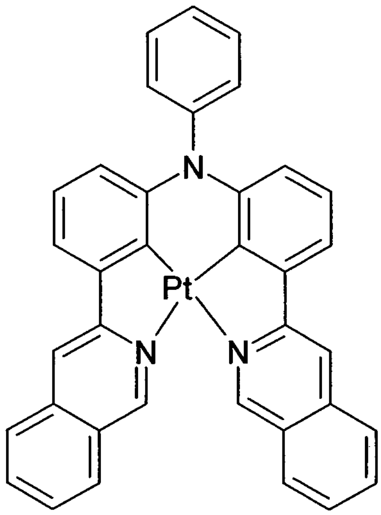 | 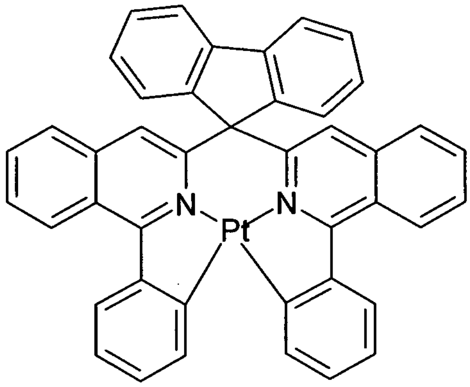 |
| (83) | (84) |
| 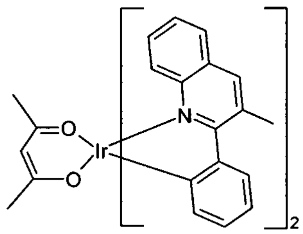 | 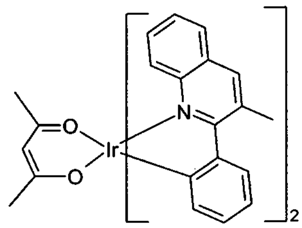 |
| (85) | (86) |
| 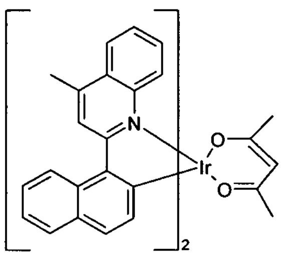 | 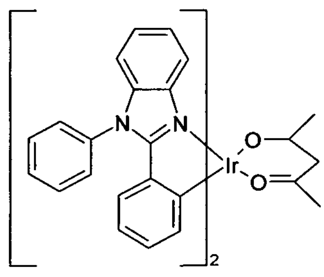 |
| (87) | (88) |

(continued)

| | |
|---|---|
| 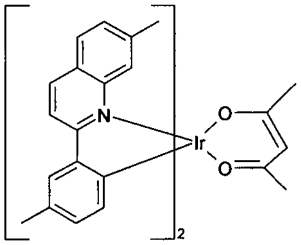 | 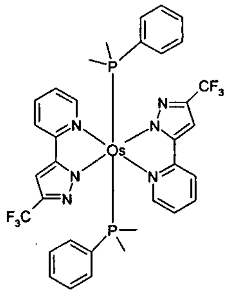 |
| (89) | (90) |
| 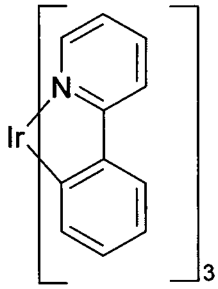 | 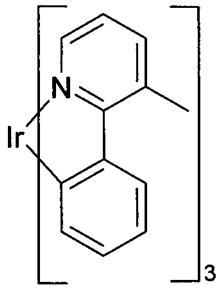 |
| (91) | (92) |
| 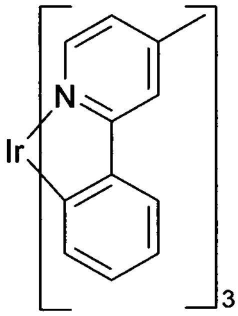 | 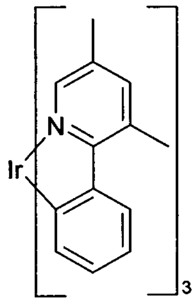 |
| (93) | (94) |
| 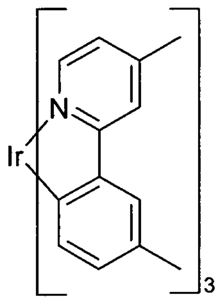 | 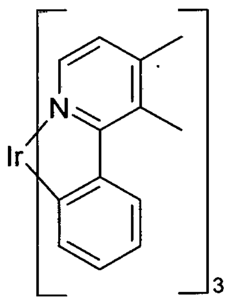 |
| (95) | (96) |

(continued)

| | |
|---|---|
| 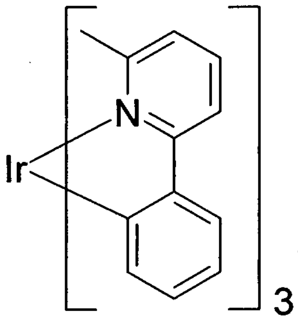 | 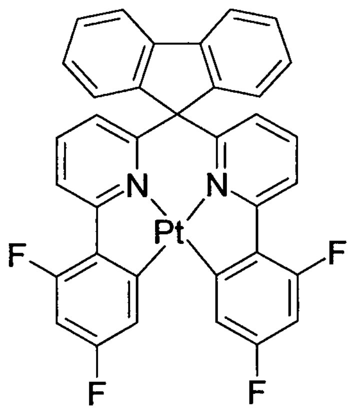 |
| (97) | (98) |
| 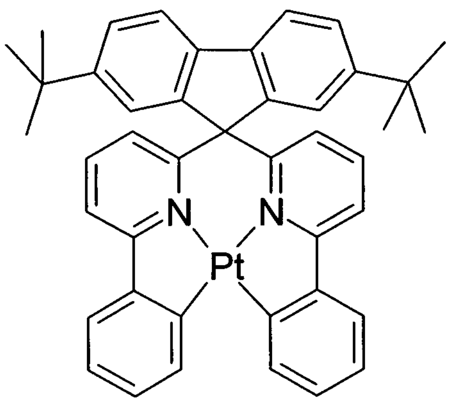 | 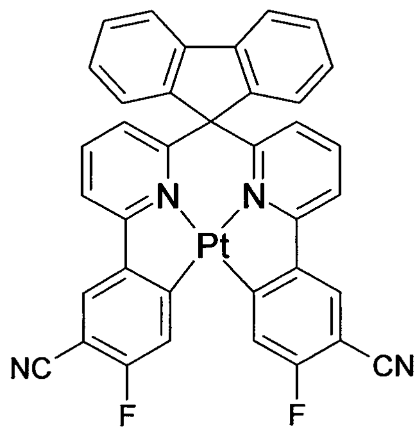 |
| (99) | (100) |
| 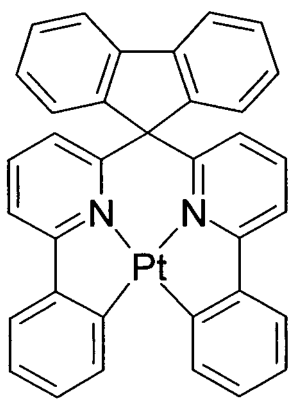 | 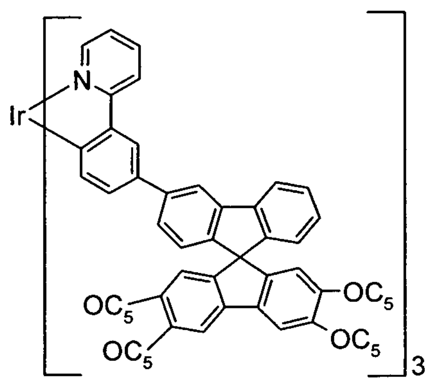 |
| (101) | (102) |

(continued)

| | |
|---|---|
| 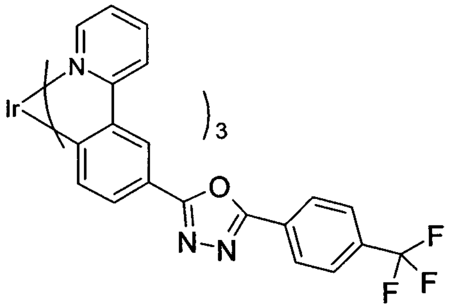 | 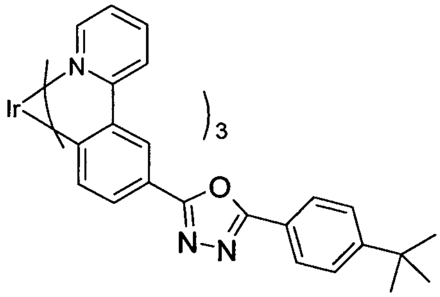 |
| (103) | (104) |
| 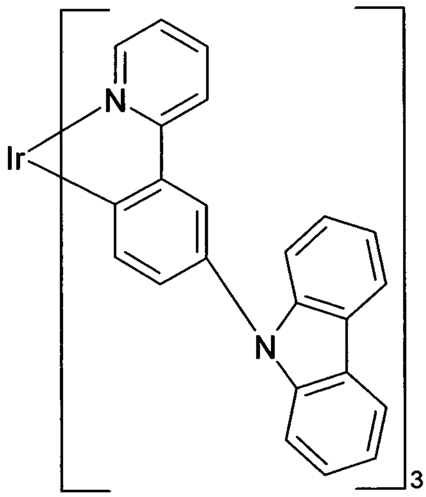 | 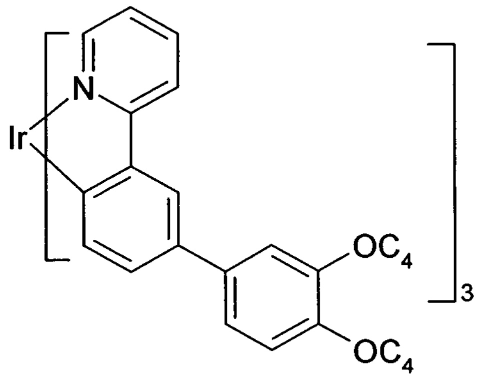 |
| (105) | (106) |
| 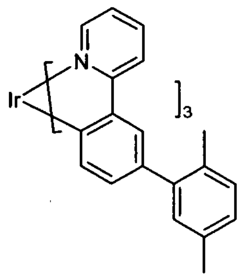 | 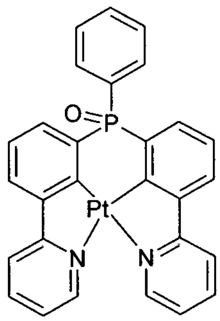 |
| (107) | (108) |

(continued)

| | |
|---|---|
| 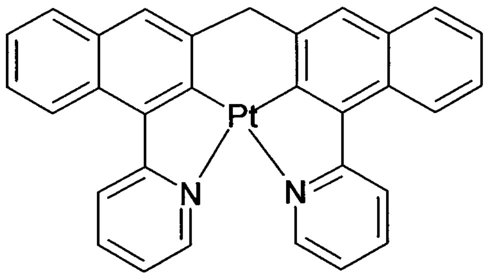 | 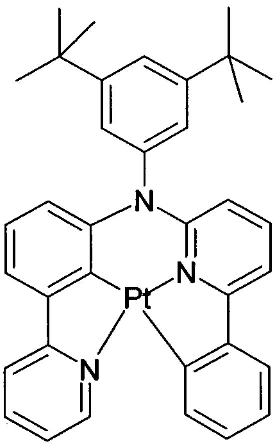 |
| (109) | (110) |
| 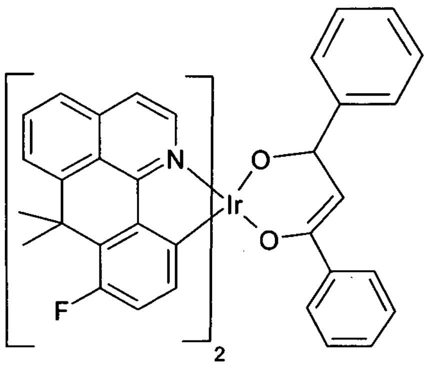 | 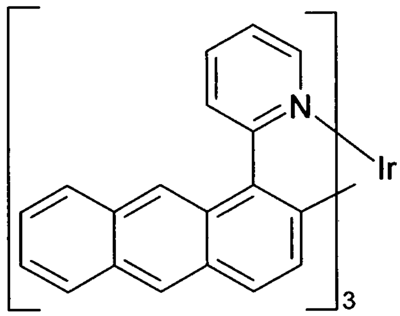 |
| (111) | (112) |
| 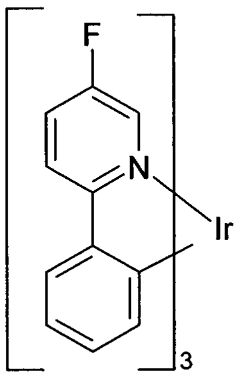 | 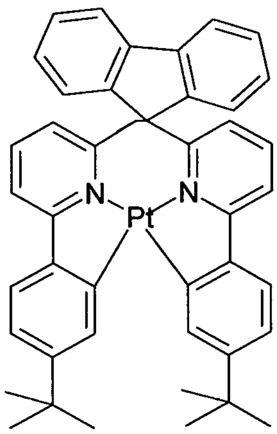 |
| (113) | (114) |

(continued)

| | |
|---|---|
| 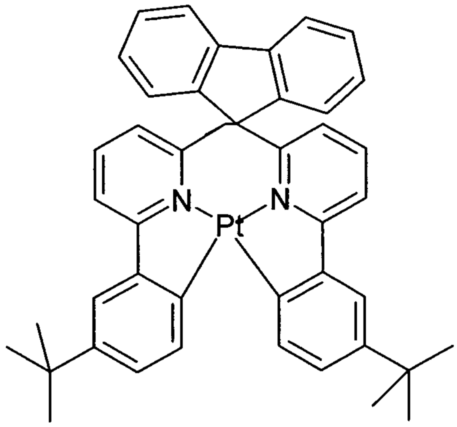 | 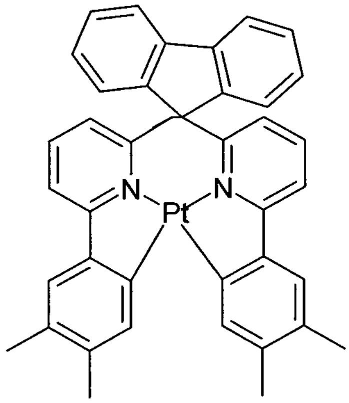 |
| (115) | (116) |
| 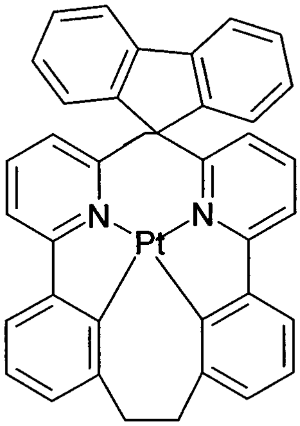 | 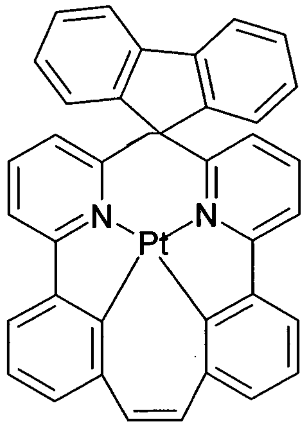 |
| (117) | (118) |
| 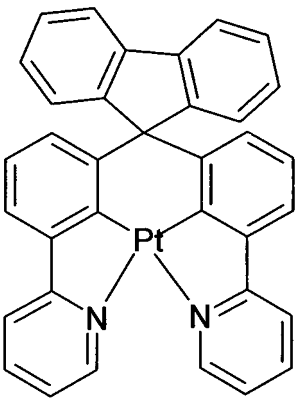 | 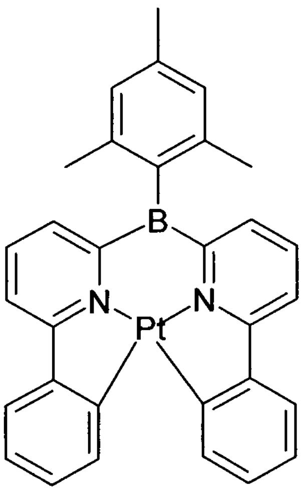 |
| (119) | (120) |

(continued)

| | |
|---|---|
| 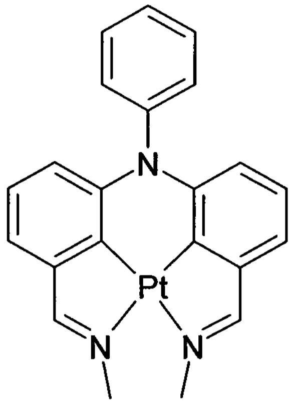 | 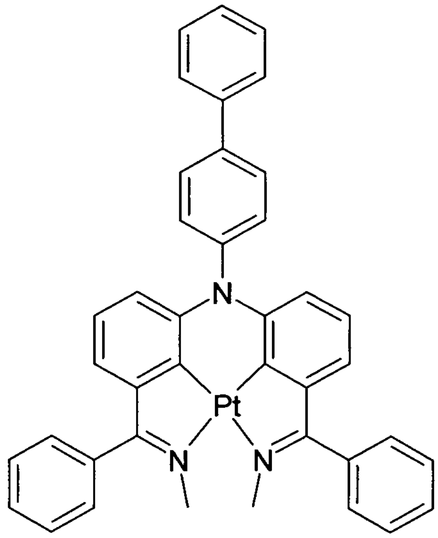 |
| (121) | (122) |
| 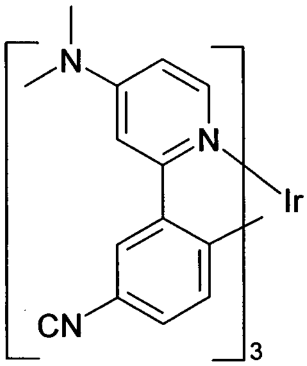 | 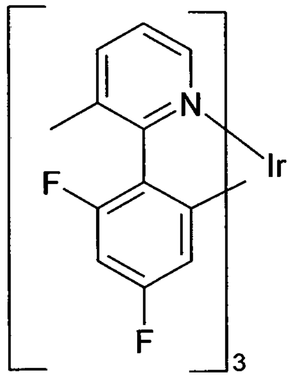 |
| (123) | (124) |
| 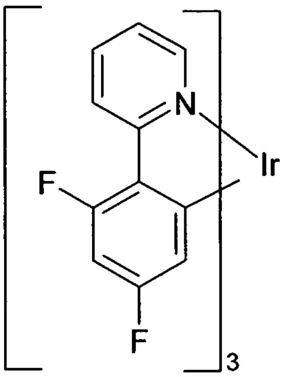 | 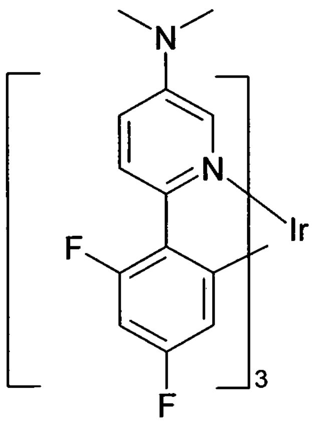 |
| (125) | (126) |

(continued)

| | |
|---|---|
| 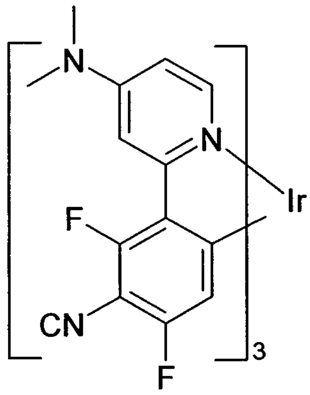 | 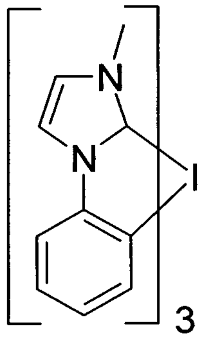 |
| (127) | (128) |
| 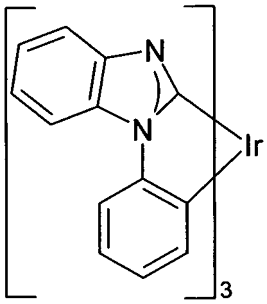 | 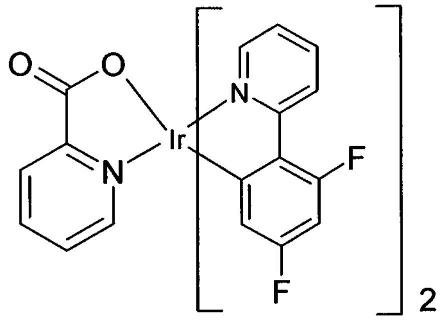 |
| (129) | (130) |
| 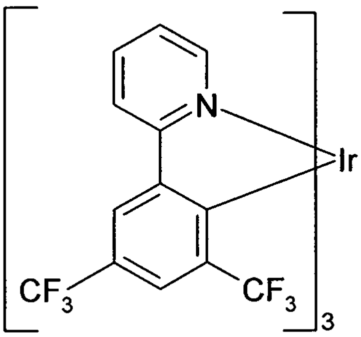 | 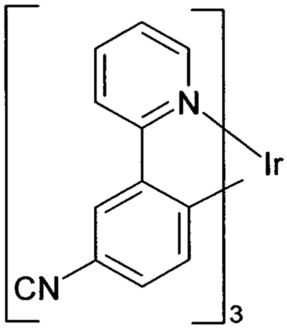 |
| (131) | (132) |
| 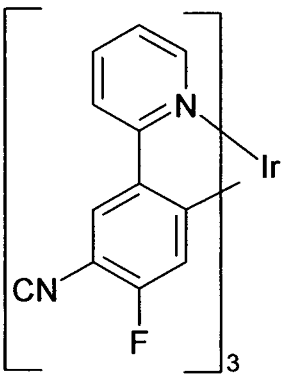 | 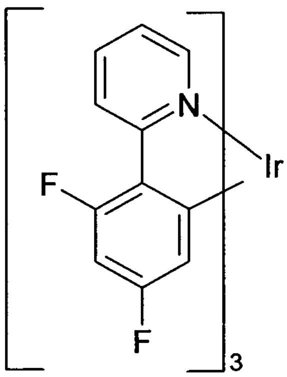 |
| (133) | (134) |

(continued)

| | |
|---|---|
| 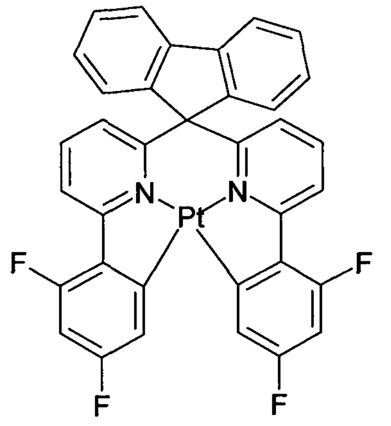 | 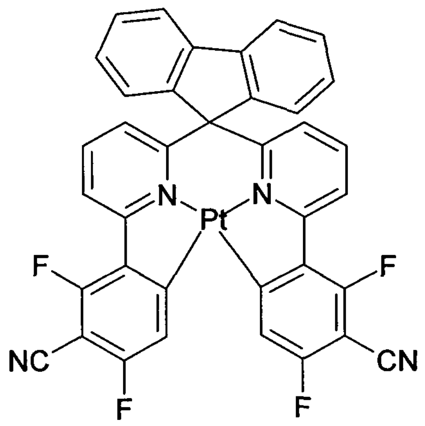 |
| (135) | (136) |
| 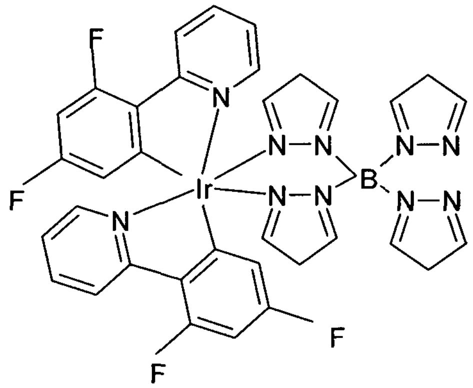 | 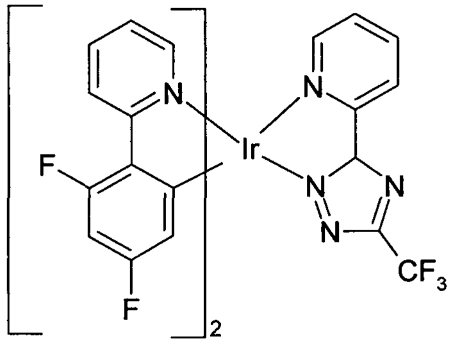 |
| (137) | (138) |
| 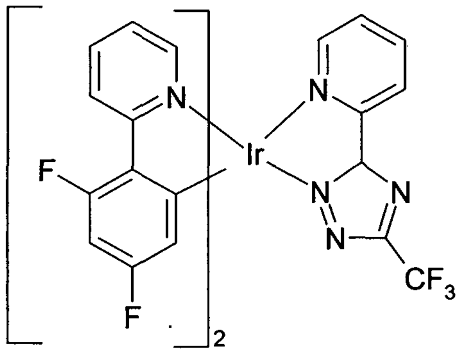 | 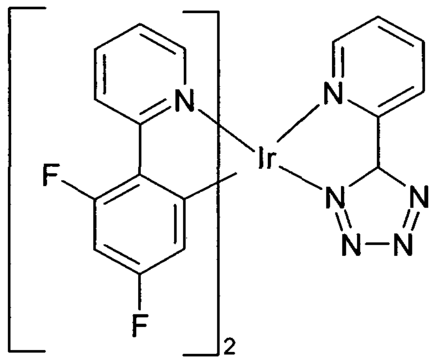 |
| (139) | (140) |

Preferred dopants are selected from the class of the monostyrylamines, the distyrylamines, the tristyrylamines, the tetrastyrylamines, the styryl-phosphines, the styryl ethers and the arylamines. A monostyrylamine is taken to mean a compound which contains one substituted or unsubstituted styryl group and at least one, preferably aromatic, amine. A distyrylamine is taken to mean a compound which contains two substituted or unsubstituted styryl groups and at least one, preferably aromatic, amine. A tristyrylamine is taken to mean a compound which contains three substituted or unsubstituted styryl groups and at least one, preferably aromatic, amine. A tetrastyrylamine is taken to mean a compound which contains four substituted or unsubstituted styryl groups and at least one, preferably aromatic, amine. The styryl groups are particularly preferably stilbenes, which may also be further substituted. Corresponding phosphines and ethers are defined analogously to the amines. For the purposes of the present invention, an arylamine or an aromatic amine is taken to mean a compound which contains three substituted or unsubstituted aromatic or heteroaromatic ring systems bonded directly to the nitrogen. At least one of these aromatic or heteroaromatic ring systems is preferably a condensed

ring system, particularly preferably having at least 14 aromatic ring atoms. Preferred examples thereof are aromatic anthraceneamines, aromatic anthracenediamines, aromatic pyreneamines, aromatic pyrenediamines, aromatic chryseneamines or aromatic chrysenediamines. An aromatic anthraceneamine is taken to mean a compound in which one diarylamino group is bonded directly to an anthracene group, preferably in the 9-position. An aromatic anthracenediamine is taken to mean a compound in which two diarylamino groups are bonded directly to an anthracene group, preferably in the 9,10-position. Aromatic pyreneamines, pyrenediamines, chryseneamines and chrysenediamines are defined analogously thereto, where the diarylamino groups are preferably bonded to the pyrene in the 1-position or in the 1,6-position. Further preferred dopants are selected from indenofluoreneamines or indenofluorenediamines, for example in accordance with WO 06/122630, benzoindenofluoreneamines or benzo-indenofluorenediamines, for example in accordance with WO 08/006449, and dibenzoindenofluoreneamines or dibenzoindenofluorenediamines, for example in accordance with WO 07/140847. Examples of dopants from the class of the styrylamines are substituted or unsubstituted tristilbeneamines or the dopants described in WO 06/000388, WO 06/058737, WO 06/000389, WO 07/065549 and WO 07/115610. Preference is furthermore given to the condensed hydrocarbons disclosed in DE 102008035413.

Suitable dopants are furthermore the structures depicted in the following table, and the derivatives of these structures disclosed in JP 06/001973, WO 04/047499, WO 06/098080, WO 07/065678, US 2005/0260442 and WO 04/092111.

| | | |
|---|---|---|
| 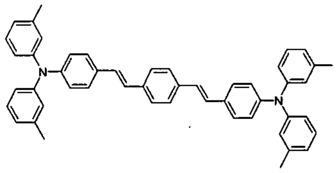 | 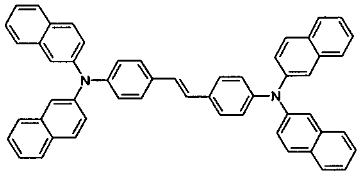 | 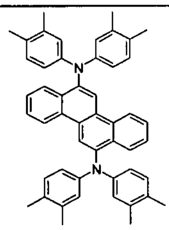 |
| 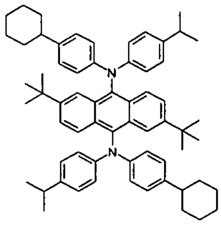 | 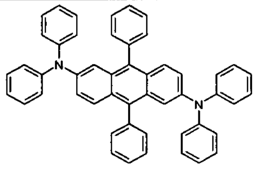 | 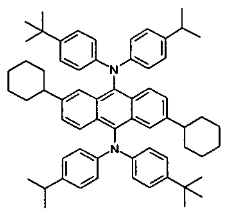 |

Another group of dopants are short (oligo-) arylenevinylenes (for example DPVBi or spiro-DPVBi in accordance with EP 676461).

The proportion of the dopand in the mixture of the emitting layer is preferably between 0.1 and 50.0 % by weight, more preferably between 0.5 and 20.0 % by weight, and most preferably between 1.0 and 10.0 % by weight. Correspondingly, the proportion of the host material is preferably between 50.0 and 99.9 % by weight, more preferably between 80.0 and 99.5 % by weight, and most preferably between 90.0 and 99.0 % by weight.

Suitable host materials for this purpose are materials from various classes of substance. Preferred host materials are selected from the classes of the oligoarylenes (for example 2,2',7,7'-tetraphenylspirobifluorene in accordance with EP 676461 or dinaphthylanthracene), in particular the oligoarylenes containing condensed aromatic groups, the oligoarylenevinylenes, the polypodal metal complexes (for example in accordance with WO 04/081017), the hole-conducting compounds (for example in accordance with WO 04/058911), the electron-conducting compounds, in particular ketones, phosphine oxides, sulfoxides, etc. (for example in accordance with WO 05/084081 and WO 05/084082), the atropisomers (for example in accordance with WO 06/048268), the boronic acid derivatives (for example in accordance with WO 06/117052), the benzanthracenes (for example in accordance with WO 08/145239), the triazines or the benzimidazoles. Suitable host materials are furthermore also the benzo[c]phenanthrene compounds according to the invention which are described above. Apart from the compounds according to the invention, particularly preferred host materials are selected from the classes of the oligoarylenes containing naphthalene, anthracene, benzanthracene and/or pyrene or atropisomers of these compounds, the oligoarylenevinylenes, the ketones, the phosphine oxides and the sulfoxides. Apart from the benzo[c]phenanthrene compounds according to the invention, very particularly preferred host materials are selected from the classes of the oligoarylenes containing anthracene, benzanthracene and/or pyrene or atropisomers of these compounds. For the purposes of this invention, an oligoarylene is intended to be taken to mean

a compound in which at least three aryl or arylene groups are bonded to one another.

Suitable host materials are furthermore, for example, the materials depicted in the following table, and derivatives of these materials, as disclosed in WO 04/018587, WO 08/006449, US 5935721, US 2005/0181232, JP 2000/273056, EP 681019, US 2004/0247937 and US 2005/0211958.

| | | |
|---|---|---|
| 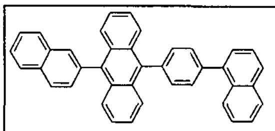 | 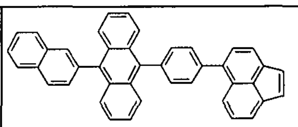 | 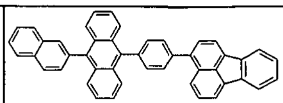 |
| 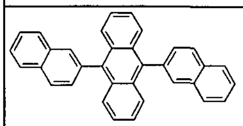 | 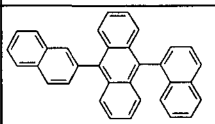 | 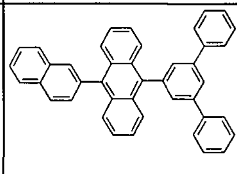 |
| 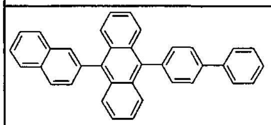 | 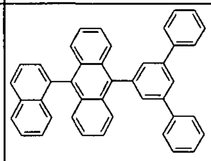 | 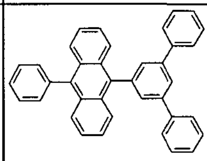 |
| 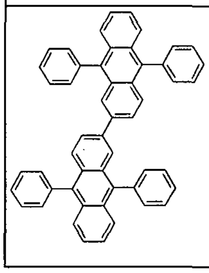 | 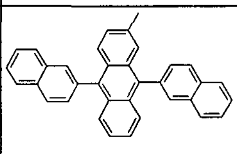 | 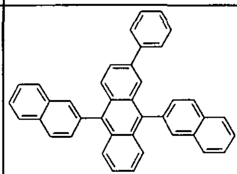 |

For the purposes of this invention, a hole-injection layer is a layer which is directly adjacent to the anode. For the purposes of this invention, a hole-transport layer is a layer which is located between a hole-injection layer and an emission layer. It may be preferred for them to be doped with electron-acceptor compounds, for example with $F_4$-TCNQ or with compounds as described in EP 1476881 or EP 1596445.

Apart from the materials according to the invention, suitable charge-transport materials, as can be used in the hole-injection or hole-transport layer or in the electron-injection or electron-transport layer of the organic electroluminescent device according to the invention, are, for example, the compounds disclosed in Y. Shirota et al., Chem. Rev. 2007, 107(4), 953-1010, or other materials as employed in these layers in accordance with the prior art.

Examples of preferred hole-transport materials which can be used in a hole-transport or hole-injection layer of the electroluminescent device according to the invention are indenofluoreneamines and derivatives (for example in accordance with WO 06/122630 or WO 06/100896), the amine derivatives as disclosed in EP 1661888, hexaazatriphenylene derivatives (for example in accordance with WO 01/049806), amine derivatives with condensed aromatics (for example in accordance with US 5,061,569), the amine derivatives as disclosed in WO 95/09147, monobenzoindenofluoreneamines (for example in accordance with WO 08/006449) or dibenzoindenofluoreneamines (for example in accordance with WO 07/140847). Suitable hole-transport and hole-injection materials are furthermore derivatives of the compounds depicted above, as disclosed in JP 2001/226331, EP 676461, EP 650955, WO 01/049806, US 4780536, WO 98/30071, EP 891121, EP 1661888, JP 2006/253445, EP 650955, WO 06/073054 and US 5061569.

Suitable hole-transport or hole-injection materials are furthermore, for example, the materials indicated in the following table.

| | | |
|---|---|---|
| 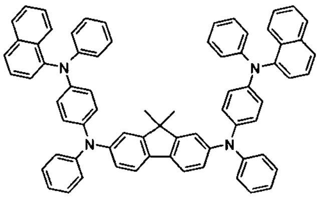 | 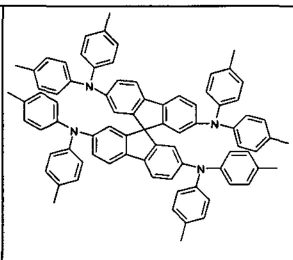 | 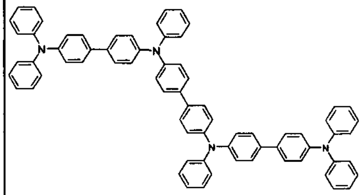 |
| 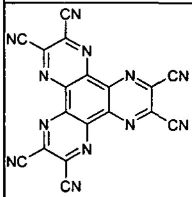 | 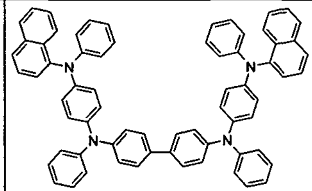 | 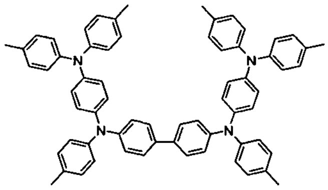 |
| 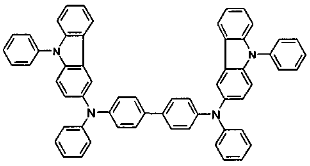 | 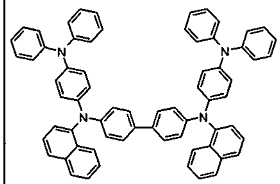 | 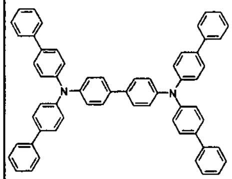 |

| | | |
|---|---|---|
| 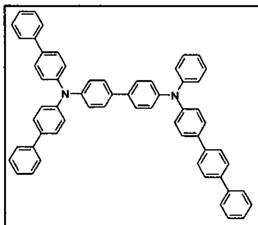 | 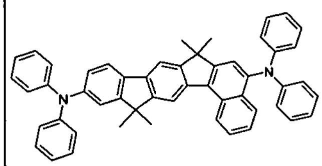 | 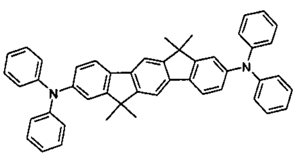 |
| 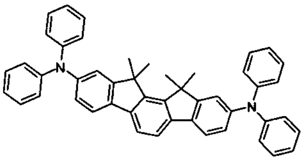 | 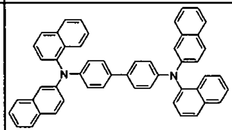 | 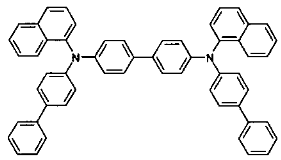 |
| 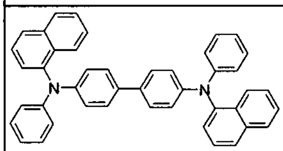 | 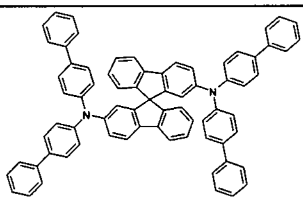 | 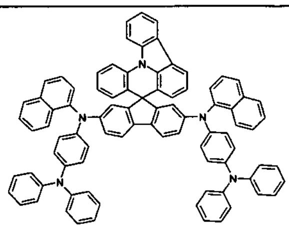 |

Suitable electron-transport or electron-injection materials which can be used in the electroluminescent device according to the invention are, for example, the materials indicated in the following table. Suitable electron-transport and electron-injection materials are furthermore derivatives of the compounds depicted above, as disclosed in JP 2000/053957, WO 03/060956, WO 04/028217 and WO 04/080975.

| | |
|---|---|
| 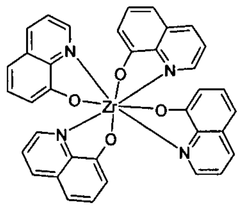 | 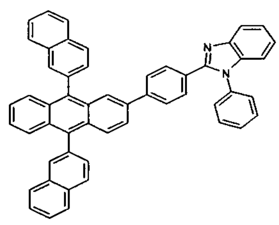 |
| 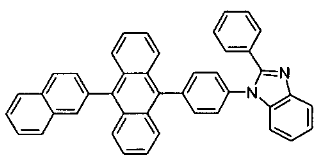 | 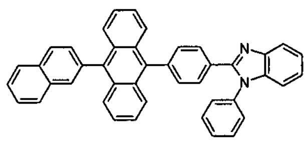 |

Suitable matrix materials for the compounds according to the invention are ketones, phosphine oxides, sulfoxides and sulfones, for example in accordance with WO 04/013080, WO 04/093207, WO 06/005627 or DE 102008033943, triarylamines, carbazole derivatives, for example CBP (N,N-biscarbazolylbiphenyl) or the carbazole derivatives disclosed in WO 05/039246, US 2005/0069729, JP 2004/288381, EP 1205527 or WO 08/086851, indolocarbazole derivatives, for example in accordance with WO 07/063754 or WO 08/056746, azacarbazoles, for example in accordance with EP 1617710, EP 1617711, EP 1731584, JP 2005/347160, bipolar matrix materials, for example in accordance with WO 07/137725, silanes, for example in accordance with WO 05/111172, azaboroles or boronic esters, for example in accordance with WO 06/117052, triazine derivatives, for example in accordance with DE 102008036982, WO 07/063754 or WO 08/056746, or zinc complexes, for example in accordance with DE 102007053771.

With further preferences charge transport materials can be used having a triacene structure, such as antracene and phenanthrene structures. Triacene structure means a condensed aromatic hydrocarbon structure having exactly three condensed aromatic rings. Regarding this embodiment of the present invention, triacene structures do not include tetracene or pentacene structures.

The light emitting materials and charge transporting materials have a molecular weight of at most 5000 g/mol, preferably at most 2000 g/mol, more preferably at most 1500 g/mol and most preferably at most 1000 g/mol.

According to a special embodiment of the present invention, the composition comprises preferably 0.01 to 20 % by weight, more preferably 0.2 to 10 % and most preferably 0.25 to 5 % by weight emitting materials and charge transporting materials.

Furthermore, the composition of the present invention comprises at least one polymer which comprises 100 mol% acrylic and/or methacrylic acid ester units. The polymer is useful as an inert binder. This means, that the polymer does not have semiconducting properties or chemically reacts with any of the semiconducting compounds in the composition. The term"chemically react" as used above and below refers to a possible oxidation or other chemical reaction of the non-conductive additive with the organic light emitting materials and/or charge transporting materials under the conditions used for manufacture, storage, transport and/or use of the formulation and the OLED device.

The polymer comprises 100 mol% of repeating units selected from acrylic and/or methacrylic acid ester units.

In a first preferred embodiment, the polymer comprises 100 mol% of repeating units selected from methacrylic acid ester units.

In a second preferred embodiment, the polymer comprises 100 mol% of repeating units selected from acrylic acid ester units.

In a third preferred embodiment, the polymer comprises 100 mol% of repeating units selected from acrylic and methacrylic acid ester units.

As methacrylic acid ester unit all units known in the prior art can be used. Preferred are methacrylic acid ester units having a $C_{1-10}$-alkyl group, a $C_{3-8}$-cycloalkyl group, a $C_{6-14}$-aryl group or a $C_{2-13}$-heteroaryl group as ester group. More preferred are methacrylic acid ester units having a methyl, an ethyl, a n-butyl, an iso-butyl, a t-butyl, a cylohexyl, an isobornyl, a benzyl or glycidly group as ester group.

As acrylic acid ester unit all units known in the prior art can be used. Preferred are acrylic acid ester units having a $C_{1-10}$-alkyl group, a $C_{3-8}$-cycloalkyl group, a $C_{6-14}$-aryl group or a $C_{2-13}$-heteroaryl group as ester group. More preferred are acrylic acid ester units having a methyl or an ethyl group as ester group.

Preferably, the polymer comprises a weight average molecular weight in the range of 750,000 to 3,000,000 g/mol. Surprising effects can be achieved with polymers having a weight average molecular weight of at least 1,000,000

g/mol.

In an especially preferred embodiment of the present invention, the polymer is a polymethylmethacrylate homopolymer having a weight average molecular weight preferably in the range of 750,000 to 3,000,000 g/mol.

Preferably, the polymer has a polydispersity index $M_w/M_n$ in the range of 1.0 to 10.0, more preferably in the range of 1.0 to 4.0 and most preferably in the range of 1.05 to 3.

Usually, the polymer is dispersible or soluble in the solvent of the present composition as described above and below. Preferably, the polymer is soluble in the organic solvent and the solubility of the polymer in the solvent is at least 1 g/l, more preferably at least 5 g/l and most preferably at least 10 g/l.

According to a special embodiment of the present invention, the composition can comprise total solids ranging preferably from 0.1 to 80 % by weight, more preferably from 1 to 50 % by weight and most preferably from 5 to 40 % by weight of one or more solid compounds.

The weight ratio of the one or more polymers with respect to the light emitting materials and charge transport materials within the composition is preferably in the range of 1:1000 to 4:1, more preferably in the range of 1:100 to 1:1 and most preferably in the range of 1:20 to 2:3.

Useful and preferred polymers comprise Hansen Solubility parameters of $H_d$ in the range of 14.5 to 23.0 $MPa^{0.5}$, $H_p$ in the range of 0.0 to 20.0 $MPa^{0.5}$ and $H_h$ in the range of 0.0 to 15.5 $MPa^{0.5}$. More preferred polymeric binders comprise Hansen Solubility parameters of $H_d$ in the range of 15.0 to 21.0 $MPa^{0.5}$, $H_p$ in the range of 1.0 to 8.0 $MPa^{0.5}$ and $H_h$ in the range of 5.0 to 15.0 $MPa^{0.5}$. Most preferred polymeric binders comprise Hansen Solubility parameters of $H_d$ in the range of 16.0 to 20.0 $MPa^{0.5}$, $H_p$ in the range of 3.0 to 5.0 $MPa^{0.5}$ and $H_h$ in the range of 5 to 12.0 $MPa^{0.5}$.

The Hansen Solubility Parameters can be determined according to the Hansen Solubility Parameters in Practice (HSPiP) program (2nd edition) as supplied by Hanson and Abbot et al.

Examples of useful polymers are disclosed in Table 1.

Table 1: Hansen Solubility Parameters of useful polymeric binders

| Polymer | $H_d$ [$MPa^{0.5}$] | $H_h$ [$MPa^{0.5}$] | $H_p$ [$MPa^{0.5}$] | $T_g$ |
|---|---|---|---|---|
| Poly(butyl methacrylate-co-isobutyl methacrylate) 1:1 | 16.8 | 3.6 | 9.7 | 35 |
| Poly(butyl methacrylate-co-methyl methacrylate) 1:1 | 16.5 | 7 | 10.3 | 52 |
| Poly(cyclohexylmethacrylate) | 17.1 | 4.5 | 7.9 | |
| Poly(isobutyl methacrylate) | 16.9 | 2.8 | 11.2 | |
| Poly(methyl methacrylate-co-butyl methacrylate) 85% methyl methacrylate | 16.3 | 8.9 | 11.8 | 105 |
| Poly(methyl methacrylate-co-ethyl acrylate) 5% ethyl acrylate | 16.2 | 9.7 | 12.2 | |
| Polybenzylmethacrylate | 18.2 | 5.7 | 8.4 | 54 |
| Polyethyl methacrylate | 16 | 7.7 | 10.3 | |
| Polymethyl methacrylate | 16.2 | 4.6 | 9.3 | |
| $H_d$ refers to Dispersion contribution<br>$H_p$ refers to Polar contribution<br>$H_h$ refers to Hydrogen bonding contribution | | | | |

According to a preferred embodiment of the present invention, the polymer has a glass transition temperature in the range of -70 to 160°C, preferably 0 to 150°C, more preferably 50 to 140°C and most preferably 70 to 130°C. The glass transition temperature can be determined by measuring the DSC of the polymer (DIN EN ISO 11357, heating rate 10°C per minute).

The composition of the present invention comprises at least one solvent, preferably at least one aromatic solvent. The solvents are preferably selected from the group consisting of aromatic hydrocarbons, like toluene, o-, m- or p-xylene, trimethyl benzenes (e.g. 1,2,3-, 1,2,4- and 1,3,5-trimethyl benzenes), tetralin, other mono-, di-, tri- and tetraalkylbenzenes (e.g. diethylbenzenes, methylcumene, tetramethylbenzenes etc), aromatic ethers (e.g. anisole, alkyl anisoles, e.g. 2, 3 and 4 isomers of methylanisole, 2,3-, 2,4-, 2,5-, 2,6-, 3,4- and 3,5- isomers of dimethylanisole), naphthalene derivatives, alkylnaphthalene derivatives (e.g. 1- and 2- methylnaphthalene), di- and tetrahydronaphthalene derivatives. Also preferred are aromatic esters (e.g alkyl benzoates), aromatic ketones (e.g. acetophenone, propiophenone), alkyl ketones (e.g. cyclohexanone), heteroaromatic solvents (e.g. thiophene, mono-, di- and trialkyl thiophenes, 2-alkylthiazoles, benzthiazoles etc, pyridines), halogenarylenes and anilin derivatives. These solvents may comprise

halogen atoms.

Especially preferred are: 3-fluoro-trifluoromethylbenzene, trifluoromethylbenzene, dioxane, trifluoromethoxybenzene, 4-fluoro-benzenetrifluoride, 3-fluoropyridine, toluene, 2-fluorotoluene, 2-fluoro-benzenetrifluoride, 3-fluorotoluene, pyridine, 4-fluorotoluene, 2,5-difluorotoluene, 1-chloro-2,4-difluorobenzene, 2-fluoropyridine, 3-chlorofluorobenzene, 1-chloro-2,5-difluorobenzene, 4-chlorofluorobenzene, chlorobenzene, 2-chlorofluorobenzene, p-xylene, m-xylene, o-xylene, 2,6-lutidine, 2-fluoro-m-xylene, 3-fluoro-o-xylene, 2-chlorobenzenetrifluoride, dimethylformamide, 2-chloro-6-fluorotoluene, 2-fluoroanisole, anisole, 2,3-dimethylpyrazine, bromobenzene, 4-fluoroanisole, 3-fluoroanisole, 3-trifluoromethylanisole, 2-methylanisole, phenetol, benzenedioxol, 4-methylanisole, 3-methylanisole, 4-fluoro-3-methylanisole, 1,2-dichloro-benzene, 2-fluorobenzenenitril, 4-fluoroveratrol, 2,6-dimethylanisole, aniline, 3-fluorobenzenenitril, 2,5-dimethylanisole, 3,4-dimethylanisole, 2,4-dimethylanisole, benzenenitril, 3,5-dimethylanisole, N,N-dimethylaniline, 1-fluoro-3,5-dimethoxybenzene, phenylacetate, N-methylaniline, methylbenzoate, N-methylpyrrolidone, morpholine, 1,2-dihydronaphthalene, 1,2,3,4-tetrahydronaphthalene, o-tolunitril, veratrol, ethylbenzoate, N,N-diethylaniline, propylbenzoate, 1-methylnaph-thalene, butylbenzoate, 2-methylbiphenyl, 2-phenylpyridin or 2,2'-Bitolyl.

More preferred are aromatic hydrocarbons especially toluene, dimethyl-benzenes (xylenes), trimethyl benzenes, dodecyl benzene, tetralin and methylnaphthalenes, aromatic ethers, especially anisole and aromatic esters, especially alkyl benzoates.

Most preferred are aromatic ethers, especially anisole and derivates thereof, such as alkyl anisoles, and aromatic esters, especially methylbenzoate.

These solvents can be used as mixture of two, three or more.

Preferred organic solvents can comprise Hansen Solubility parameters of $H_d$ in the range of 17.0 to 23.2 $MPa^{0.5}$, $H_p$ in the range of 0.2 to 12.5 $MPa^{0.5}$ and $H_h$ in the range of 0.9 to 14.2 $MPa^{0.5}$. More preferred organic solvents comprise Hansen Solubility parameters of $H_d$ in the range of 18.5 to 21.0 $MPa^{0.5}$, $H_p$ in the range of 2.0 to 6.0 $MPa^{0.5}$ and $H_h$ in the range of 2.0 to 6.0 $MPa^{0.5}$.

Table 2: Hansen Solubility Parameters of useful solvents

| Solvent | $H_d$ [$MPa^{0.5}$] | $H_h$ [$MPa^{0.5}$] | $H_p$ [$MPa^{0.5}$] |
|---|---|---|---|
| 1,2,3,4-tetrahydro-1-naphthol | 19.6 | 9.2 | 12.8 |
| 1,2,3,4-tetrahydronaphthalene | 19.1 | 2.3 | 4.0 |
| 1,2,3,4-tetramethylbenzene | 18.7 | 1.8 | 1.6 |
| 1,2,3,5-tetramethylbenzene | 18.7 | 1.8 | 1.6 |
| 1,2,3-trimethylbenzene | 19.0 | 2.9 | 1.6 |
| 1,2,4,5-tetramethylbenzene | 18.7 | 1.8 | 1.6 |
| 1,2,4-trichlorobenzene | 20.5 | 6.9 | 2.7 |
| 1,2,4-trimethylbenzene | 19.0 | 2.9 | 1.6 |
| 1,2-dihydronaphthalene | 20.1 | 5.5 | 4.9 |
| 1,2-dimethylnaphthalene | 21.0 | 1.7 | 5.2 |
| 1,3,3-trimethyl-2-methyleneindole | 17.9 | 1.0 | 3.0 |
| 1,3-benzodioxole | 19.7 | 7.4 | 7.9 |
| 1,3-diisopropylbenzene | 17.5 | 0.2 | 1.1 |
| 1,3-dimethylnaphthalene | 21.0 | 1.7 | 5.2 |
| 1,4-benzodioxane | 19.5 | 8.7 | 7.2 |
| 1,4-diisopropylbenzene | 17.5 | 0.6 | 1.6 |
| 1,4-dimethylnaphthalene | 21.0 | 1.7 | 5.2 |
| 1,5-dimethyltetralin | 19.3 | 5.5 | 2.6 |
| 1-benzothiophene | 19.7 | 12.3 | 6.3 |
| 1-bromonaphthalene | 23.1 | 10.3 | 6.1 |
| 1-chloromethyl naphthalene | 22.1 | 9.9 | 5.3 |

(continued)

| Solvent | $H_d$ [$MPa^{0.5}$] | $H_h$ [$MPa^{0.5}$] | $H_p$ [$MPa^{0.5}$] |
|---|---|---|---|
| 1-ethylnaphthalene | 20.7 | 7.8 | 4.4 |
| 1-methoxynaphthalene | 21.4 | 10.5 | 7.5 |
| 1-methylnaphthalene | 21.7 | 8.4 | 4.5 |
| 1-methylindane | 19.4 | 5.7 | 2.5 |
| 1-methylindole | 19.2 | 8.1 | 10.2 |
| 2,3,3-trimethoxyindolenine | 19.6 | 6.8 | 4.2 |
| 2,3-benzofuran | 21.3 | 5.5 | 5.6 |
| 2,3-dihydrobenzofuran | 19.9 | 9.5 | 6.6 |
| 2,3-dimethylanisol | 18.9 | 4.6 | 4.5 |
| 2,4-dimethylanisol | 18.9 | 4.6 | 4.5 |
| 2,5-dimethylanisol | 18.9 | 4.6 | 4.5 |
| 2,6-diisopropyl naphthalene | 18.3 | 3.5 | 2.2 |
| 2,6-dimethylanisol | 18.9 | 4.6 | 4.5 |
| 2,6-dimethylnaphthalene | 20.1 | 5.0 | 3.0 |
| 2-bromo-3-bromomethyl)thiophene | 19.3 | 7.3 | 6.6 |
| 2-bromomethyl naphthalene | 22.0 | 9.4 | 7.2 |
| 2-bromonaphthalene | 23.1 | 10.3 | 6.1 |
| 2-ethoxynaphthalene | 20.5 | 10.0 | 7.0 |
| -ethylnaphthalene | 20.7 | 7.8 | 4.4 |
| 2-isopropylanisol | 17.7 | 4.3 | 5.4 |
| 2-methyl quinoline | 20.0 | 7.8 | 4.0 |
| 2-methylanisol | 18.3 | 5.1 | 6.2 |
| 2-methylindole | 17.8 | 9.7 | 4.8 |
| 2-phenoxyethanol | 18.7 | 8.5 | 13.0 |
| 3,4-dimethylanisol | 18.9 | 4.6 | 4.5 |
| 3,5-dimethylanisol | 18.9 | 4.6 | 4.5 |
| 3-bromoquinoline | 21.4 | 8.7 | 5.1 |
| 3-isopropylbiphenyl | 19.1 | 1.3 | 1.9 |
| 3-methylanisol | 18.7 | 5.7 | 5.4 |
| 4-benzylacetone | 18.3 | 8.8 | 5.0 |
| 4-isopropylbiphenyl | 19.0 | 2.5 | 1.9 |
| 4-methoxybenzyl alcohol | 19.0 | 8.5 | 13.3 |
| 4-methylanisol | 18.6 | 5.9 | 7.2 |
| 4-phenyl-2-butanone | 18.3 | 8.8 | 5.0 |
| 5,6,7,8-tetrahydro-1-naphthol | 19.6 | 7.2 | 10.9 |
| 5,6,7,8-tetrahydro-2-naphthol | 19.6 | 7.2 | 10.9 |
| 5,6,7,8-tetrahydro-2-naphthylamine | 20.1 | 7.9 | 8.6 |
| 5,6.7,8-tetrahydro-1-naphthylamine | 20.1 | 7.9 | 8.6 |

(continued)

| Solvent | $H_d$ [$MPa^{0.5}$] | $H_h$ [$MPa^{0.5}$] | $H_p$ [$MPa^{0.5}$] |
|---|---|---|---|
| 5-decanolide | 17.1 | 7.8 | 3.8 |
| 5-methoxyindan | 19.8 | 9.8 | 4.0 |
| 5-methoxyindole | 17.4 | 12.3 | 7.8 |
| 5-tert-butyl-m-xylene | 17.6 | 3.4 | 2.2 |
| 6-methoxy-1,2,3,4-tetrahydronapthalene | 19.4 | 6.8 | 5.4 |
| 6-methyl quinoline | 21.7 | 8.4 | 4.5 |
| 8-methyl quinoline | 21.7 | 8.4 | 4.5 |
| Acetophenone | 18.8 | 10.8 | 5.5 |
| Anisole | 18.5 | 5.5 | 5.2 |
| $\alpha$-pinene | 17.4 | 3.0 | 3.2 |
| Benzonitrile | 19.2 | 11.9 | 4.7 |
| Benzothiazole | 21.3 | 5.5 | 5.6 |
| benzyl acetate | 18.2 | 7.3 | 6.4 |
| benzyl alcohol | 19.1 | 6.7 | 14.2 |
| Bromobenzene | 19.8 | 7.6 | 4.3 |
| Butylbenzene | 17.6 | 2.6 | 1.7 |
| Butylbenzoate | 17.7 | 5.9 | 5.2 |
| Cyclohexylbenzene | 18.6 | 1.0 | 1.6 |
| Decahydronaphthalene | 17.5 | 0.4 | 1.0 |
| diphenyl ether | 19.9 | 2.9 | 3.3 |
| ethylphenylketon (propiophenone) | 18.3 | 8.9 | 5.3 |
| Ethylbenzene | 18.2 | 2.7 | 2.1 |
| Ethylbenzoate | 18.1 | 6.6 | 5.9 |
| furfuryl alcohol | 18.1 | 6.7 | 11.9 |
| gamma-terpinene | 18.0 | 2.5 | 2.8 |
| Hexylbenzene | 17.4 | 2.9 | 1.6 |
| Indane | 19.7 | 7.3 | 5.8 |
| Indene | 20.3 | 4.4 | 5.4 |
| iso-amylbenzene | 17.1 | 3.7 | 1.8 |
| iso-butylbenzene | 17.1 | 2.9 | 1.6 |
| isopropylbenzene (cumene) | 17.8 | 2.0 | 1.1 |
| m-cymene | 18.1 | 2.0 | 2.1 |
| Mesitylene | 19.0 | 2.9 | 1.6 |
| methyl benzoate | 18.5 | 7.9 | 6.4 |
| Methylphenylacetate | 18.2 | 7.3 | 6.4 |
| n-xylene | 18.8 | 3.1 | 2.7 |
| n-butoxybenzene | 17.5 | 4.4 | 4.1 |
| n-butylbenzene | 17.6 | 2.6 | 1.7 |

(continued)

| Solvent | $H_d$ [$MPa^{0.5}$] | $H_h$ [$MPa^{0.5}$] | $H_p$ [$MPa^{0.5}$] |
|---|---|---|---|
| n-propyl benzoate | 17.8 | 6.6 | 6.3 |
| n-propylbenzene | 17.8 | 3.4 | 2.8 |
| o-dichlorobenzene | 19.5 | 8.7 | 3.3 |
| o-diethylbenzenes | 17.7 | 0.7 | 1.9 |
| o-ethyltoluene | 18.0 | 1.9 | 2.8 |
| o-xylene | 18.4 | 2.0 | 2.9 |
| Pentylbenzene | 17.4 | 3.0 | 1.8 |
| p-ethyltoluene | 18.3 | 3.5 | 2.8 |
| Phenetol | 18.1 | 4.6 | 4.6 |
| phenyl acetate | 18.5 | 7.9 | 6.4 |
| p-isopropyltoluene (p-cymene) | 18.0 | 2.5 | 2.8 |
| Propiophenone | 18.3 | 8.9 | 5.3 |
| Propylbenzoate | 17.8 | 6.6 | 6.3 |
| p-xylene | 18.7 | 3.3 | 3.3 |
| sec-butylbenzene | 17.2 | 2.2 | 1.6 |
| t-butylbenzene | 17.2 | 1.3 | 2.9 |
| Tetralin | 19.1 | 2.3 | 4.0 |
| Thiophene | 18.8 | 5.2 | 7.4 |
| Toluene | 18.6 | 4.0 | 2.2 |
| Veratrole | 18.2 | 6.3 | 7.5 |
| $H_d$ refers to Dispersion contribution<br>$H_p$ refers to Polar contribution<br>$H_h$ refers to Hydrogen bonding contribution | | | |

Preferably the solvent has a boiling point or sublimation temperature of < 300°C, more preferably ≤ 260°C, most preferably ≤ 220°C, at the pressure employed, preferably at atmospheric pressure (1013 hPa). Evaporation can also be accelerated e.g. by applying heat and/or reduced pressure. Unexpected improvements can be achieved by using solvents having a boiling point of at least 100°C, preferably at least 130°C.

Usually, the organic solvent can comprise a surface tension of at least 28 mN/m, preferably at least 30 mN/m, more preferably at least 32 mN/m and most preferably at least 35 mN/m. The surface tension can be measured using a FTA (First Ten Angstrom) 1000 contact angle goniometer at 25°C. or a Kruss DSA 100. Details of the method are available from First Ten Angstrom as published by Roger P. Woodward, Ph.D. "Surface Tension Measurements Using the Drop Shape Method". Preferably, the pendant drop method can be used to determine the surface tension.

For the purpose for making a rough estimate, the surface tension can be calculated using the Hansen Solubility Parameters by the formula expounded in Hansen Solubility Parameters: A User’s Handbook, Second Edition, C. M. Hansen (2007), Taylor and Francis Group, LLC (HSPiP manual).

$$\text{Surface tension} = 0.0146 \times (2.28 \times \delta H_d^2 + \delta H_p^2 + \delta H_h^2) \times MVol^{0.2},$$

where:

$H_d$ refers to Dispersion contribution
$H_p$ refers to Polar contribution

$H_h$ refers to Hydrogen bonding contribution
MVol refers to Molar Volume.

The Hansen Solubility Parameters can be determined according to the Hansen Solubility Parameters in Practice (HSPiP) program (2nd edition) as supplied by Hanson and Abbot et al.

Preferably, the solvent comprises a relative evaporation rate (Butyl acetate = 100) of at least 0.01, preferably of at least 0.1, more preferably of at least 1 and most preferably of at least 10. The relative evaporation rate can be determined according to DIN 53170: 2009-08. For the purpose for making a rough estimate, the relative evaporation rate can be calculated using the Hansen Solubility Parameters with the HSPiP program as mentioned above and below.

Preferably, the polymer increases the solvent viscosity by at least 0.4 cps when dissolving 0,5 to 1 % w/w of the polymer in said organic solvent.

The composition of the present invention preferably comprises at least 70 % by weight, more preferably at least 80 % by weight and most preferably at least 90 % by weight of organic solvents.

The composition according to the present invention may additionally comprise one or more further components like for example surface-active compounds, lubricating agents, wetting agents, dispersing agents, hydrophobing agents, adhesive agents, flow improvers, defoaming agents, deaerators, diluents which may be reactive or non-reactive, auxiliaries, colourants, dyes or pigments, sensitizers, stabilizers, nanoparticles or inhibitors. However, these further components should not be oxidising or otherwise capable of chemically reacting with the organic light emitting materials and/or charge transport materials or have an electrically doping effect on the organic light emitting materials and/or charge transporting materials.

Surprising improvements can be achieved with volatile wetting agents. The term "volatile" as used above and below means that the agent can be removed from the organic light emitting materials and/or charge transporting materials by evaporation, after these materials have been deposited onto a substrate of an OLED device, under conditions (like temperature and/or reduced pressure) that do not significantly damage these materials or the OLED device. Preferably this means that the wetting agent has a boiling point or sublimation temperature of ≤ 350°C, more preferably ≤ 300°C, and most preferably ≤ 250°C, at the pressure employed, preferably at atmospheric pressure (1013 hPa). Evaporation can also be accelerated e.g. by applying heat and/or reduced pressure.

Surprising effects can be accomplished by compositions comprising volatile components having similar boiling points. Preferably, the difference of the boiling point of the wetting agent and the organic solvent is in the range of -50°C to 50°C, more preferably in the range of -30°C to 30°C and most preferably in the range of -20°C to 20°C.

Preferred wetting agents are non-aromatic compounds. With further preference the wetting agents are non-ionic compounds. Particular useful wetting agents comprise a surface tension of at most 35 mN/m, preferably of at most 30 mN/m, and more preferably of at most 25 mN/m. The surface tension can be measured using a FTA (First Ten Angstrom) 1000 contact angle goniometer at 25°C or a Kruss DSA 100. Details of the method are available from First Ten Angstrom as published by Roger P. Woodward, Ph.D. "Surface Tension Measurements Using the Drop Shape Method". Preferably, the pendant drop method can be used to determine the surface tension.

According to a special aspect of the present invention, the difference of the surface tension of the organic solvent and the wetting agent is preferably at least 1 mN/m, more preferably at least 5 mN/m and most preferably at least 10 mN/m.

According to a special aspect of the present invention the wetting additive comprises a relative evaporation rate (Butyl acetate = 100) of at least 0.01, preferably of at least 0.1, more preferably of at least 1, and most preferably of at least 10.

Unexpected improvements can be achieved with compositions comprising solvents and wetting agents having a similar relative evaporation rate (Butyl acetate = 100). Preferably, the difference of the relative evaporation rate (Butyl acetate = 100) of the wetting agent and the organic solvent is in the range of -20 to 20, more preferably in the range of -10 to 10. According to a preferred embodiment of the present invention, the ratio of the relative evaporation rate (Butyl acetate = 100) of the wetting agent to relative evaporation rate (Butyl acetate = 100) of the organic solvent can range from 230:1 to 1:230, preferably from 20:1 to 1:20 and more preferably from 5:1 to 1:5.

Unexpected improvements can be achieved by wetting agents comprising a molecular weight of at least 100 g/mol, preferably at least 150 g/mol, more preferably at least 180 g/mol and most preferably at least 200 g/mol. Suitable and preferred wetting agents that do not oxidise or otherwise chemically react with the organic semiconducting materials are selected from the group consisting of siloxanes, alkanes, amines, alkenes, alkynes, alcohols and/or halogenated derivates of these compounds. Furthermore, fluoro ethers, fluoro esters and/or fluoro ketones can be used. More preferably, these compounds are selected from methyl siloxanes having 6 to 20 carbon atoms, especially 8 to 16 carbon atoms; $C_7$-$C_{14}$ alkanes, $C_7$-$C_{14}$ alkenes, $C_7$-$C_{14}$ alkynes, alcohols having 7 to 14 carbon atoms, fluoro ethers having 7 to 14 carbon atoms, fluoro esters having 7 to 14 carbon atoms and fluoro ketones having 7 to 14 carbon atoms. Most preferred wetting agents are methylsiloxanes having 8 to 14 carbon atoms.

Useful and preferred alkanes having 7 to 14 carbon atoms include heptane, octane, nonane, decane, undecane,

dodecane, tridecane, tetradecane, 3-methylheptane, 4-ethylheptane, 5-propyldecane, trimethylcyclohexane and decalin.

Halogenated alkanes having 7 to 14 carbon atoms include 1-chloroheptane, 1,2-dichlorooctane, tetrafluorooctane, decafluorododecane, perfluorononane, 1,1,1-trifluoromethyldecane, and perfluoromethyldecalin.

Useful and preferred alkenes having 7 to 14 carbon atoms include heptene, octene, nonene, 1-decene, 4-decene, undecene, dodecene, tridecene, tetradecene, 3-methylheptene, 4-ethylheptene, 5-propyldecene, and trimethylcyclohexene.

Halogenated alkenes having 7 to 14 carbon atoms include 1-chloroheptene, 1,2-dichlorooctene, tetrafluorooctene, decafluorododecene, perfluoro-nonene, and 1,1,1-trifluoromethyldecene.

Useful and preferred alkynes having 7 to 14 carbon atoms include heptyne, octyne, nonyne, 1-decyne, 4-decyne, undecyne, dodecyne, tridecyne, tetradecyne, 3-methylheptyne, 4-ethylheptyne, 5-propyldecyne, and trimethylcyclohexyne.

Halogenated alkynes having 7 to 14 carbon atoms include 1-chloroheptyne, 1,2-dichlorooctyne, tetrafluorooctyne, decafluorododecyne, perfluorononyne, and 1,1,1-trifluoromethyldecyne.

Useful and preferred alcohols having 7 to 14 carbon atoms include 3,5-dimethyl-1-hexyn-3-ol, heptanol, octanol, nonanol, decanol, undecanol, dodecanol, tridecanol, tetradecanol, 3-methylheptanol, 4-ethylheptanol, 5-propyldecanol, trimethylcyclohexanol and hydroxyldecalin.

Halogenated alkanols having 7 to 14 carbon atoms include 1-chloroheptanol, 1,2-dichlorooctanol, tetrafluorooctanol, decafluorododecanol, perfluorononanol, 1,1,1-trifluoromethyldecanol, and 2-trifluoromethyl-1-hydroxydecalin.

Useful and preferred amines having 4 to 15 carbon atoms include hexylamine, tripropylamine, tributylamine, dibutylamine, piperazine, heptylamine, octylamine, nonylamine, decylamine, undecylamine, dodecylamine, tridecylamine, tetradecylamine, 3-methylheptylamine, 4-ethylheptylamine, 5-propyldecylamine, trimethylcyclohexylamine.

Halogenated amines having 4 to 15 carbon atoms include 1-chloroheptylamine, 1,2-dichlorooctylamine, tetrafluorooctylamine, decafluorododecylamine, perfluorononylamine, 1,1,1-trifluoromethyldecylamine, perfluorotributylamine, and perfluorotripentylamine.

Useful and preferred fluoro ethers having 7 to 14 carbon atoms include 3-ethoxy-1,1,1,2,3,4,4,5,5,6,6,6 dodecafluoro-2-trifluoromethyl-hexane, 3-propoxy-1,1,1,2,3,4,4,5,5,6,6,6 dodecafluoro-2-trifluoromethyl-hexane, 3-ethoxy-1,1,1,2,3,4,4,5,5,6,6,7,7,7 tetradecafluoro-2-trifluoromethyl-heptane, 3-ethoxy-1,1,1,2,3,4,4,5,5,5 decafluoro-2-trifluoromethyl-pentane, and 3-propoxy-1,1,1,2,3,4,4,5,5,5 decafluoro-2-trifluoromethyl-pentane.

Useful and preferred fluoro esters having 7 to 14 carbon atoms include 3-(1,1,1,2,3,4,4,5,5,6,6,6 dodecafluoro-2-trifluoromethyl-hexyl) ethanoate, 3-(1,1,1,2,3,4,4,5,5,6,6,6 dodecafluoro-2-trifluoromethyl-hexyl) propanoate, 3-(1,1,1,2,3,4,4,5,5,6,6,7,7,7 tetradecafluoro-2-trifluoromethyl-heptyl) ethanoate, 3-(1,1,1,2,3,4,4,5,5,5 decafluoro-2-trifluoromethyl-pentyl) ethanoate, and 3-(1,1,1,2,3,4,4,5,5,5 decafluoro-2-trifluoromethyl-pentyl) propanoate.

Useful and preferred fluoroketones having 7 to 14 carbon atoms include 3-(1,1,1,2,3,4,4,5,5,6,6,6 dodecafluoro-2-trifluoromethyl-hexyl) ethylketone, 3-(1,1,1,2,3,4,4,5,5,6,6,6 dodecafluoro-2-trifluoromethyl-hexyl) propylketone, 3-(1,1,1,2,3,4,4,5,5,6,6,7,7,7 tetradecafluoro-2-trifluoromethylheptyl) ethylketone, 3-(1,1,1,2,3,4,4,5,5,5 decafluoro-2-trifluoromethyl-pentyl) ethylketone, and 3-(1,1,1,2,3,4,4,5,5,5 decafluoro-2-trifluoromethyl-pentyl) propylketone.

Useful and preferred siloxanes include hexamethyldisiloxane, octamethyltrisiloxane, decamethyltetrasiloxane, dodecamethylpentasiloxane, and tetradecamethylhexasiloxane.

Examples of compounds useful as wetting agents are disclosed in Table 3. The provided relative evaporation rate (RER) and surface tension values are calculated using the Hansen Solubility Parameters with the HSPiP program provided by Hanson and Abbott et al. as mentioned above and below.

Table 3: Preferred wetting agents

| Wetting agent | Boiling point [°C] | $H_d$ [$MPa^{0.5}$] | $H_h$ [$MPa^{0.5}$] | $H_p$ [$MPa^{0.5}$] | $M_{Vol}$ | RER | Surface tension [mN/m] |
|---|---|---|---|---|---|---|---|
| Decane | 174 | 15.5 | 0 | 0 | 194 | 19.9 | 23.0 |
| 3-Octanol | 175 | 15.5 | 6 | 10 | 159.3 | 2.2 | 27.5 |
| 1-Decene | 169 | 15.5 | 1.5 | 2.3 | 188.4 | 13.9 | 23.1 |
| 1-Octyn-3-ol | 195 | 15.5 | 8.8 | 10.2 | 147 | 2.6 | 28.9 |
| 4-Octyne | 129 | 14.6 | 0 | 2.6 | 148.3 | 81.8 | 19.6 |
| 1-Decyne | 174 | 15.5 | 0.1 | 3.3 | 181.4 | 15.1 | 23.1 |
| 1-Dodecyne | 215 | 15.7 | 0.1 | 3.3 | 213.5 | 1.4 | 24.5 |

(continued)

| Wetting agent | Boiling point [°C] | $H_d$ [$MPa^{0.5}$] | $H_h$ [$MPa^{0.5}$] | $H_p$ [$MPa^{0.5}$] | $M_{Vol}$ | RER | Surface tension [mN/m] |
|---|---|---|---|---|---|---|---|
| Perfluorononane | 125 | 13.3 | 0 | -0.3 | 283.6 | 393.1 | 18.2 |
| Hexamethyl disiloxane | 128 | 13 | 1.5 | 0.8 | 207.2 | 505.2 | 16.5 |
| Octamethyl trisiloxane | 153 | 12.6 | 1.5 | 0.4 | 283.4 | 56 | 16.5 |
| Decamethyl tetrasiloxane | 194 | 12.3 | 1.4 | 0.1 | 359.7 | 7.4 | 16.4 |
| Dodecamethy pentasiloxane | 230 | 12 | 1.3 | -0.1 | 436 | 1.1 | 16.2 |
| Perfluoromethyl decalin | 150 | 11.8 | 0 | 1.2 | 275.8 | 16.6 | 14.3 |
| 3,5 Dimethyl-1-hexyn-3-ol | 160 | 15.2 | 5.5 | 13.2 | 145.7 | 0.8 | 28.9 |
| 3-Ethoxy-1,1,1,2, 3,4,4,5,5, 6,6,6 dodecafluoro-2-trifluoromethyl-hexane | 128 | 13.2 | 2.7 | 1.8 | 266.9 | 1946 | 18.2 |
| Perfluorotributyl amine | 174 | 12.9 | 0 | 0 | 383.3 | 0.2 | 18.2 |
| Perfluorotripentyl amine | 215 | 13.2 | 0 | 0 | 462.7 | <0.1 | 19.8 |
| Tripropylamine | 156 | 15.5 | 3.9 | 2.1 | 189 | 28.6 | 23.6 |
| Tributylamine | 216 | 15.7 | 2.1 | 1.7 | 240.4 | 2.2 | 24.9 |
| dibutylamine | 159 | 15.3 | 2.2 | 4.4 | 171.0 | 22.4 | 22.8 |
| Hexylamine | 132 | 15.7 | 5.0 | 9.3 | 132.1 | 30.5 | 26.1 |
| Piperazine | 145 | 16.9 | 4.4 | 6.7 | 97 | 22.8 | 26.1 |
| $H_d$ refers to Dispersion contribution<br>$H_p$ refers to Polar contribution<br>$H_h$ refers to Hydrogen bonding contribution<br>$M_{Vol}$ refers to Molar Volume. | | | | | | | |

Preferably, the composition comprises at most 5 % by weight, more preferably at most 3 % by weight and most preferably at most 1% by weight of wetting additives. Preferably, the composition comprises 0.01 to 5 % by weight, more preferably 0.1 to 3 % by weight of wetting agent.

Preferably, the solvent should be selected such that it can be evaporated from the coated or printed layer comprising the emitting materials and/or charge transporting materials together with the wetting agent, preferably in the same processing step. The processing temperature used for removing the solvent and the volatile additive should be selected such that the layer, comprising the organic light emitting materials and/or charge transporting materials, is not damaged. Preferably the deposition processing temperature is from room temperature (RT; about 25°C) to 135°C and more preferably from RT to 100°C.

Preferably, the composition of the present invention comprises a surface tension in the range of 20 to 60 mN/m, more preferably 25 to 45 mN/m. The surface tension can be measured using a FTA (First Ten Angstrom) 1000 contact angle goniometer or Kruss DSA 100 as mentioned above and below. The surface tension can be achieved by selection the polymeric binder and the solvent in an appropriate manner. The use of the Hanson Solubility Parameters as mentioned above provides a useful aid for a person skilled in the art. Furthermore, the surface tension can be achieved by using a wetting agent, preferably a volatile wetting agent as mentioned above.

Preferably, the composition has a viscosity in the range of 1 to 100 mPas, preferably in the range of 2.0 to 40 mPas, more preferably in the range of 2.1 to 20 mPas and most preferably in the range of 2.1 to 15 mPas. The viscosity is determined at a temperature of 25°C by measuring on a MARS III rheometer manufactured by Haake. This is measured using a 1° cone-plate geometry.

Preferably, the composition can be filtered e.g. to 1 micron or less.

During the process of preparing an OLED device, the layer, comprising the organic light emitting materials and/or charge transporting materials, is deposited onto a substrate, followed by removal of the solvent together with any volatile conductive additive(s) present, to form a film or layer.

The substrate can be any substrate suitable for the preparation of OLED devices, or can also be the OLED device, or a part thereof. Suitable and preferred substrates are e.g. glass, ITO coated glass, ITO glass with pre coated layers including PEDOT, PANI etc, flexible films of polyethylene terephthalate (PET), polyethylene naphthalate (PEN), polyimide, and flexible films with ITO, or other conducting layers and barrier layers e.g. Vitex film.

Deposition of the layer, comprising the organic light emitting materials and/or charge transporting materials, can be achieved by standard methods that are known to the skilled person and are described in the literature. Suitable and preferred deposition methods include liquid coating and printing techniques. Very preferred deposition methods include, without limitation, dip coating, spin coating, ink jet printing, nozzle printing, letter-press printing, screen printing, gravure printing, doctor blade coating, roller printing, reverse-roller printing, offset lithography printing, flexographic printing, web printing, spray coating, curtain coating, brush coating, airbrush coating, slot dye coating or pad printing. Gravure, flexographic and inkjet printing are preferred.

Removal of the solvent and any volatile conductive additive(s) is preferably achieved by evaporation, for example by exposing the deposited layer to high temperature and/or reduced pressure, preferably at 50 to 200°C, more preferably at 60 to 135°C.

The thickness of the layer, comprising the organic light emitting materials and/or charge transporting materials, is preferably from 1 nm to 500 nm, more preferably from 2 to 150 nm.

Further to the materials and methods as described above and below, the OLED device and its components can be prepared from standard materials and standard methods, which are known to the person skilled in the art and described in the literature.

It will be appreciated that variations to the foregoing embodiments of the invention can be made while still falling within the scope of the invention, as defined by the claims. Each feature disclosed in this specification, unless stated otherwise, may be replaced by alternative features serving the same, equivalent or similar purpose. Thus, unless stated otherwise, each feature disclosed is one example only of a generic series of equivalent or similar features.

All of the features disclosed in this specification may be combined in any combination, except combinations where at least some of such features and/or steps are mutually exclusive. In particular, the preferred features of the present invention are applicable to all aspects of the invention and may be used in any combination. Likewise, features described in non-essential combinations may be used separately (not in combination).

It will be appreciated that many of the features described above, particularly of the preferred embodiments, are inventive in their own right and not just as part of an embodiment of the present invention. Independent protection may be sought for these features in addition to or alternative to any invention presently claimed.

Unless the context clearly indicates otherwise, as used herein plural forms of the terms herein are to be construed as including the singular form and vice versa.

Throughout the description and claims of this specification, the words "comprise" and "contain" and variations of the words, for example "comprising" and "comprises", mean "including but not limited to", and are not intended to (and do not) exclude other components.

The term "polymer" includes homopolymers and copolymers, e.g. statistical, alternating or block copolymers. In addition, the term "polymer" as used hereinafter does also include oligomers and dendrimers. Dendrimers are typically branched macromolecular compounds consisting of a multifunctional core group onto which further branched monomers are added in a regular way giving a tree-like structure, as described e.g. in M. Fischer and F. Vögtle, Angew. Chem., Int. Ed. 1999, 38, 885.

The term "conjugated polymer" means a polymer containing in its backbone (or main chain) mainly C atoms with $sp^2$-hybridisation, or optionally sp-hybridisation, which may also be replaced by hetero atoms, enabling interaction of one $\pi$-orbital with another across an intervening $\sigma$-bond. In the simplest case this is for example a backbone with alternating carbon-carbon (or carbon-hetero atom) single and multiple (e.g. double or triple) bonds, but does also include polymers with units like 1,3-phenylene. "Mainly" means in this connection that a polymer with naturally (spontaneously) occurring defects, which may lead to interruption of the conjugation, is still regarded as a conjugated polymer. Also included in this meaning are polymers wherein the backbone comprises for example units like aryl amines, aryl phosphines and/or certain heterocycles (i.e. conjugation via N-, O-, P- or S-atoms) and/or metal organic complexes (i.e. conjugation via a metal atom). The term "conjugated linking group" means a group connecting two rings (usually aromatic rings) consisting of C atoms or hetero atoms with $sp^2$-hybridisation or sp-hybridisation. See also "IUPAC Compendium of Chemical terminology, Electronic version".

Unless stated otherwise, the molecular weight is given as the number average molecular weight $M_n$ or as weight average molecular weight $M_w$, which unless stated otherwise are determined by gel permeation chromatography (GPC) against polystyrene standards.

The degree of polymerization (n) means the number average degree of polymerization, unless stated otherwise given as $n = M_n/M_U$, wherein $M_U$ is the molecular weight of the single repeating unit.

The term "small molecule" means a monomeric, i.e. a non-polymeric compound.

Unless stated otherwise, percentages of solids are per cent by weight ("wt. %"), percentages or ratios of liquids

(like e.g. in solvent mixtures) are per cent by volume ("vol. %"), and all temperatures are given in degrees Celsius (°C).

Unless stated otherwise, concentrations or proportions of mixture components, like the conductive additives, given in percentages or ppm are related to the entire formulation including the solvents.

The invention will now be described in more detail by reference to the following examples, which are illustrative only and do not limit the scope of the present invention.

## Working Examples

### Comparative Example 1

A printing ink was prepared by mixing a phosphorescent compound according to formula (A)

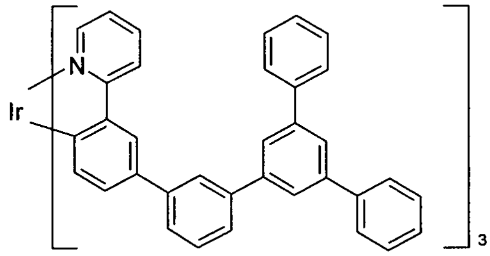

(A)

a host material according to formula (B)

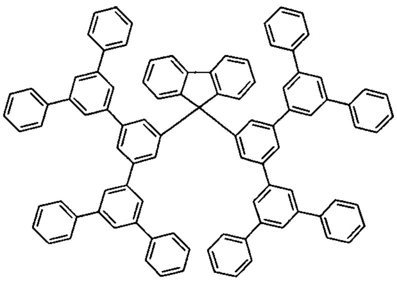

(B)

and a host material according to formula (C)

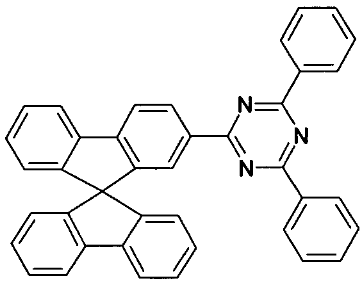

(C)

in a weight ratio A:B:C of 1:2:2 and dissolving the mixture obtained in anisole. The concentration of the semiconducting compounds was about 2.5 % by weight.

The OLED ink was gravure printed using a RK K printing proofer on PET substrates (120 x 220 mm) covered with 10 substrates (25 x 25 mm) having each a 4 pixels structure of ITO and a gravure printed PEDOT layer. Two drying procedures were used, a hot plate at 120°C and hot air convection dryer at 120°C to assess the differences in film quality.

Gravure printing of this formulation yields in an extremely poor film quality, as can be seen in Figure 3.

### Comparative Example 2

Essentially, Comparative Example 1 was repeated. However, an inert polystyrene binder has been added to the printing ink. The printing ink comprises 0.5 % by weight polystyrene having a $M_w$ of 2,000,000 g/mol (as supplied

by Sigma Aldrich) and 2.5 % by weight of the semiconducting compounds as mentioned in Comparative Example 1.

The wetting on PEDOT and PET was better than in comparative example 1, but not good. Wetting show significant issues, as can be seen in Figure 4.

## Comparative Example 3

Essentially, Comparative Example 1 was repeated. However, an inert polystyrene binder has been added to the printing ink. The printing ink comprises 1.0 % by weight polystyrene having a $M_w$ of 2,000,000 g/mol (as supplied by Sigma Aldrich) and 2.5 % by weight of the semiconducting compounds as mentioned in Comparative Example 1.

A better wetting on PEDOT was achieved than in Comparative Example 2. Nevertheless, large pinholes are visible in the layer, as can be seen in Figure 5. However, the results are improved in comparison to Comparative Examples 1 and 2.

## Example 4

Essentially, Comparative Example 1 was repeated. However, an inert poly(methyl methacrylate) binder has been added to the printing ink. The printing ink comprises 0.25 % by weight poly(methyl methacrylate) having a $M_w$ of 2,400,000 g/mol (as supplied by Sigma Aldrich) and 2.5 % by weight of the semiconducting compounds as mentioned in Comparative Example 3.

A better wetting on the PEDOT layer was achieved. The results are improved in comparison to Comparative Example 3.

## Example 5

Essentially, Comparative Example 1 was repeated. However, an inert poly(methyl methacrylate) binder has been added to the printing ink. The printing ink comprises 0.5 % by weight poly(methyl methacrylate) having a $M_w$ of 2,400,000 g/mol (as supplied by Sigma Aldrich) and 2.5 % by weight of the semiconducting compounds as mentioned in Example 4.

A very good film quality and wetting on PEDOT after drying has been achieved. The results are improved in comparison to Example 4, as can be seen in Figure 6.

## Device Examples 6 and 7

Device Preparation of solution-processed OLEDs

Many examples are described in the literature about the preparation of organic light emitting diodes from solution, mostly for polymer devices ("PLEDs", e.g. WO 2004/037887 A2). To illustrate that the inventive formulations of the present invention not only lead to better films but also perform well, OLED devices were made in a standard test setup. The typical setup is depicted in Figure 1, the used device layout is shown in Figure 2. ITO (Indium-Tin-Oxide) is a transparent, hole injecting anode that was deposited onto PET foil by sputtering and structured via gravure printed lithography to obtain ten substrates each consisting of 4 pixels, 6 x 4 mm in size. In the present case the substrates were self prepared.

The 175-µm-thick polyethylene terephthalate (PET) substrates are cleaned in a cleanroom environment using Acetone and IPA in an ultrasonic bath. The surface is then activated with a UV/ozone treatment. As a first layer about 60 nm of PEDOT was deposited by gravure printing onto the substrate and dried for 60 minutes at 130°C. (PEDOT is a water-based dispersion of PEDOT, a polythiophene, and PSSH, polysulfonic-acid, available from H.C. Starck, Goslar; used here is Clevios P 4083 Al, but other PEDOT-products from H. C. Starck or "buffer" materials from other suppliers will work as well.). The film thickness of the EML is about 100 nm, and the substrates are annealed again for 10 minutes at 130°C to remove remaining solvent. The viscosity of the solution changes with solid concentration, i. e. with small molecule, polymeric contents and inert film former content. In the following examples, anisole is used as solvent, but other solvents (see specification) can be used as well. In this case, the gravure printing conditions and drying procedures have to be adjusted accordingly. The dry layers were examined after the printing run using a Canon EOS 550D digital camera under UV light excitation and an Olympus BX51 polarized light microscope with LMPLFLN 20× objective.

To make electrical contact a cathode structure is vacuum deposited through a metal mask on top of the organic films. The cathode may consist of just one metal (e.g. Yb), be a two-layer structure of a reactive and thus electron injecting metal (such as Mg, Ba, Sr, etc.) in combination with a capping metal (typically Al or Ag), be a two- or three-layer structure containing an alkali or earth alkali fluoride or oxide as the first deposited layer (e.g. LiF, $Li_2O$, $BaF_2$, BaO, MgO, NaF, etc.), or have one or more vacuum deposited electron transport layers followed by the right electron injection

metal or metal fluoride, oxide or quinolate. In the present case only Ca and Al are deposited to keep the devices simple and show that even such a simple setup can render very good devices. To close the organic and cathode structure against moisture and/or oxygen the devices are encapsulated and can then be handled outside the glovebox.

Characterization is done with a setup from Botest. The devices are fixed in a sample holder with spring-contacts connecting anode and cathode to the measurement circuit. A photodiode with an eye-correction filter is put tightly on top to prevent outside light from falsifying the results. Then the voltage is increased stepwise to 10 V in steps of 0.2 V while the current through the sample and the photocurrent from the photodiode are measured. This way the so-called IVL-data (current, voltage, luminance) are collected. Important data are the maximum efficiency (in cd/A), the external quantum efficiency (EQE) in %, and the required voltage for a certain brightness.

**Examples 6 and 7:**

**Comparison of devices with an inert polystyrene (PS) binder and with an inert poly(mehyl methacrylate) (PMMA) binder**

**Comparative Example 6**

Compounds (A), (B) and (C) were dissolved in anisole at a concentration of 25 g/l, in addition polystyrene (2.000.000 g/mol, Aldrich) is added as the inert binder at a concentration of 5 g/l to improve film formation and gravure printed. The results of the device characterization are shown in Table 4.

**Example 7**

Compounds (A), (B) and (C) were dissolved in anisole at a concentration of 25 g/l, in addition poly (methyl methacrylate) (2.400.000 g/mol, Aldrich) is added as the inert binder at a concentration of 5 g/l to improve film formation and gravure printed. The results of the device characterization are shown in Table 4.

Table 4

| Ex. | Max. Eff. [cd/A] | Additive |
|---|---|---|
| 6 | 6 | Polystyrene |
| 7 | 20 | Poly (methyl methacrylate) |

## Claims

1. Composition comprising one or more organic light emitting materials having a molecular weight of at most 5000 g/mol and one or more charge transport materials having a molecular weight of at most 5000 g/mol, one or more organic solvents, and one or more polymers, **characterized in that** said one or more polymers comprise 100 mol% acrylic acid ester and/or methacrylic acid ester units and **in that** said one or more polymers have a weight average molecular weight $M_w$ in the range from 750,000 to 3,000,000 g/mol.

2. Composition according to claim 1, **characterized in that** the acrylic and/or methacrylic acid ester units are selected from acrylic and/or methacrylic acid ester units having a $C_{1-10}$-alkyl group, a $C_{3-8}$-cycloalkyl group, a $C_{6-14}$-aryl group or a $C_{2-13}$-heteroaryl group as ester group.

3. Composition according to one or more of claims 1 or 2, **characterized in that** said composition comprises a viscosity at 25°C in the range of 1 to 100 mPas.

4. Composition according to one or more of claims 1 to 3, **characterized in that** said polymer has a glass transition temperature in the range of -70 to 160°C.

5. Composition according to one or more of claims 1 to 4, **characterized in that** said composition comprises in the range of 0.01 to 20 % by weight of said polymers.

6. Composition according to one or more of claims 1 to 5, **characterized in that** said organic solvent is an aromatic organic solvent.

7. Composition according to claim 6, **characterized in that** said organic solvent is selected from the group consisting of aromatic hydrocarbons, aromatic ethers, aromatic esters, aromatic ketones, heteroaromatic solvents and aniline derivatives.

8. Composition according to one or more of claims 1 to 7, **characterized in that** said organic solvent has a boiling point of ≤ 260°C.

9. Composition according to one or more of claims 1 to 8, **characterized in that** said composition comprises at least 80 % by weight of said organic solvents.

10. Composition according to one or more of claims 1 to 9, **characterized in that** said one or more organic light emitting material having a molecular weight of at most 5000 g/mol is an organic phosphorescent compound which emits light and in addition contains at least one atom having an atomic number greater than 38.

11. Composition according to claim 10, **characterized in that** said organic phosphorescent compound is selected from a compound of formulae (1) to (4):

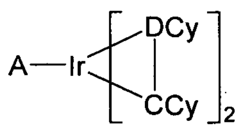

formula (1)

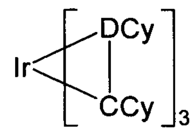

formula (2)

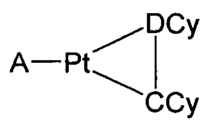

formula (3)

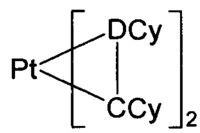

formula (4)

where

DCy is, identically or differently on each occurrence, a cyclic group which contains at least one donor atom, preferably nitrogen, carbon in the form of a carbene or phosphorus, via which the cyclic group is bonded to the metal, and which may in turn carry one or more substituents $R^1$; the groups DCy and CCy are connected to one another via a covalent bond;
CCy is, identically or differently on each occurrence, a cyclic group which contains a carbon atom via which the cyclic group is bonded to the metal and which may in turn carry one or more substituents $R^1$;
A is, identically or differently on each occurrence, a monoanionic, bidentate chelating ligand, preferably a diketonate ligand;
$R^1$ are, identically or differently at each instance, and are F, Cl, Br, I, $NO_2$, CN, a straight-chain, branched or cyclic alkyl or alkoxy group having from 1 to 20 carbon atoms, in which one or more nonadjacent $CH_2$ groups may be replaced by -O-, -S-, $-NR^2-$, $-CONR^2-$, -CO-O-, -C=O-, -CH=CH- or -C≡C-, and in which one or more hydrogen atoms may be replaced by F, or an aryl or heteroaryl group which has from 4 to 14 carbon atoms and may be substituted by one or more nonaromatic $R^1$ radicals, and a plurality of substituents $R^1$, either on the same ring or on the two different rings, may together in turn form a mono- or polycyclic, aliphatic or aromatic ring system; and
$R^2$ are, identically or differently at each instance, and are a straight-chain, branched or cyclic alkyl or alkoxy group having from 1 to 20 carbon atoms, in which one or more nonadjacent $CH_2$ groups may be replaced by -O-, -S-, -CO-O-, -C=O-, -CH=CH- or -C≡C-, and in which one or more hydrogen atoms may be replaced by F, or an aryl or heteroaryl group which has from 4 to 14 carbon atoms and may be substituted by one or more nonaromatic $R^1$ radicals.

12. Composition according to one or more of claims 1 to 11, **characterized in that** said composition comprises 0.25 to 5 % by weight organic light emitting materials and charge transporting materials having a molecular weight of at most 5000 g/mol.

**13.** Use of a composition according to one or more of claims 1 to 12 as coating or printing ink for the preparation of organic electroluminescent (EL) devices, preferably OLED devices.

**14.** Organic electroluminescent device, preferably OLED device, prepared from a composition according to one or more of claims 1 to 12.

## Patentansprüche

**1.** Zusammensetzung enthaltend ein oder mehrere organische lichtemittierende Materialien mit einem Molekulargewicht von höchstens 5000 g/mol und ein oder mehrere Ladungstransportmaterialien mit einem Molekulargewicht von höchstens 5000 g/mol, ein oder mehrere organische Lösungsmittel und ein oder mehrere Polymere, **dadurch gekennzeichnet, dass** das eine oder die mehreren Polymere 100 mol% Acrylsäureester- und/oder Methacrylsäureestereinheiten enthalten und dass das eine oder die mehreren Polymere ein gewichtsmittleres Molekulargewicht $M_w$ im Bereich von 750.000 bis 3.000.000 g/mol aufweisen.

**2.** Zusammensetzung nach Anspruch 1, **dadurch gekennzeichnet, dass** die Acryl- und/oder Methacrylsäureestereinheiten aus Acryl- und/oder Methacrylsäureestereinheiten mit einer $C_{1-10}$-Alkylgruppe, einer $C_{3-8}$-Cycloalkylgruppe, einer $C_{6-14}$-Arylgruppe oder einer $C_{2-13}$-Heteroarylgruppe als Estergruppe ausgewählt sind.

**3.** Zusammensetzung nach einem oder mehreren der Ansprüche 1 oder 2, **dadurch gekennzeichnet, dass** die Zusammensetzung eine Viskosität bei 25°C im Bereich von 1 bis 100 mPas umfasst.

**4.** Zusammensetzung nach einem oder mehreren der Ansprüche 1 bis 3, **dadurch gekennzeichnet, dass** das Polymer eine Glasübergangstemperatur im Bereich von -70 bis 160°C aufweist.

**5.** Zusammensetzung nach einem oder mehreren der Ansprüche 1 bis 4, **dadurch gekennzeichnet, dass** die Zusammensetzung im Bereich von 0,01 bis 20 Gew.-% der Polymere enthält.

**6.** Zusammensetzung nach einem oder mehreren der Ansprüche 1 bis 5, **dadurch gekennzeichnet, dass** es sich bei dem organischen Lösungsmittel um ein aromatisches organisches Lösungsmittel handelt.

**7.** Zusammensetzung nach Anspruch 6, **dadurch gekennzeichnet, dass** das organische Lösungsmittel aus der Gruppe bestehend aus aromatischen Kohlenwasserstoffen, aromatischen Ethern, aromatischen Estern, aromatischen Ketonen, heteroaromatischen Lösungsmitteln und Anilinderivaten ausgewählt ist.

**8.** Zusammensetzung nach einem oder mehreren der Ansprüche 1 bis 7, **dadurch gekennzeichnet, dass** das organische Lösungsmittel einen Siedepunkt von $\leq$ 260°C aufweist.

**9.** Zusammensetzung nach einem oder mehreren der Ansprüche 1 bis 8, **dadurch gekennzeichnet, dass** die Zusammensetzung mindestens 80 Gew.-% der organischen Lösungsmittel enthält.

**10.** Zusammensetzung nach einem oder mehreren der Ansprüche 1 bis 9, **dadurch gekennzeichnet, dass** es sich bei dem einen oder den mehreren organischen lichtemittierenden Material mit einem Molekulargewicht von höchstens 5000 g/mol um eine organische phosphoreszierende Verbindung handelt, die Licht emittiert und zusätzlich mindestens ein Atom mit einer Ordnungszahl größer als 38 enthält.

**11.** Zusammensetzung nach Anspruch 10, **dadurch gekennzeichnet, dass** die organische phosphoreszierende Verbindung aus einer Verbindung der Formeln (1) bis (4) ausgewählt ist:

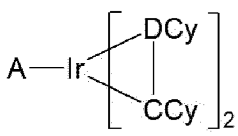

Formel (1)

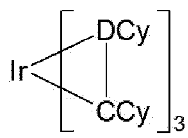

Formel (2)

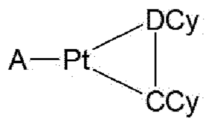

Formel (3)

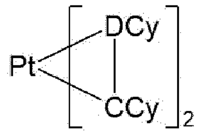

Formel (4)

wobei

DCy gleich oder verschieden bei jedem Auftreten eine cyclische Gruppe ist, die mindestens ein Donoratom, vorzugsweise Stickstoff, Kohlenstoff in Form eines Carbens oder Phosphor, enthält, über das die cyclische Gruppe an das Metall gebunden ist, und die wiederum einen oder mehrere Substituenten $R^1$ tragen kann; die Gruppen DCy und CCy sind über eine kovalente Bindung miteinander verbunden;
CCy gleich oder verschieden bei jedem Auftreten eine cyclische Gruppe ist, die ein Kohlenstoffatom enthält, über das die cyclische Gruppe an das Metall gebunden ist, und die wiederum einen oder mehrere Substituenten $R^1$ tragen kann;
A gleich oder verschieden bei jedem Auftreten ein monoanionischer, zweizähniger chelatbildender Ligand, vorzugsweise ein Diketonat-Ligand ist;
$R^1$ bei jedem Auftreten gleich oder verschieden sind und F, Cl, Br, I, $NO_2$, CN, eine geradkettige, verzweigte oder cyclische Alkyl- oder Alkoxygruppe mit 1 bis 20 Kohlenstoffatomen, in der eine oder mehrere nicht benachbarte $CH_2$-Gruppen durch -O-, -S-, $-NR^2-$, $-CONR^2-$, -CO-O-, -C=O-, -CH=CH- oder -C≡C- ersetzt sein können und in der ein oder mehrere Wasserstoffatome durch F ersetzt sein können, oder eine Aryl- oder Heteroarylgruppe, die 4 bis 14 Kohlenstoffatome aufweist und durch einen oder mehrere nichtaromatische Reste $R^1$ substituiert sein kann, sind, und eine Mehrzahl von Substituenten $R^1$, entweder am gleichen Ring oder an zwei verschiedenen Ringen, können zusammen wiederum ein mono- oder polycyclisches, aliphatisches oder aromatisches Ringsystem bilden; und
$R^2$ bei jedem Auftreten gleich oder verschieden sind und eine geradkettige, verzweigte oder cyclische Alkyl- oder Alkoxygruppe mit 1 bis 20 Kohlenstoffatomen, in der eine oder mehrere nicht benachbarte $CH_2$-Gruppen durch -O-, -S-, -CO-O-, -C=O-, -CH=CH- oder -C≡C- ersetzt sein können und in der ein oder mehrere Wasserstoffatome durch F ersetzt sein können, oder eine Aryl- oder Heteroarylgruppe, die 4 bis 14 Kohlenstoffatome aufweist und durch einen oder mehrere nichtaromatische Reste $R^1$ substituiert sein kann, sind.

**12.** Zusammensetzung nach einem oder mehreren der Ansprüche 1 bis 11, **dadurch gekennzeichnet, dass** die Zusammensetzung 0,25 bis 5 Gew.-% organische lichtemittierende Materialien und Ladungstransportmaterialien mit einem Molekulargewicht von höchstens 5000 g/mol enthält.

**13.** Verwendung einer Zusammensetzung nach einem oder mehreren der Ansprüche 1 bis 12 als Beschichtung oder Druckfarbe zur Herstellung von organischen Elektrolumineszenz(EL)-Vorrichtungen, vorzugsweise OLED-Vorrichtungen.

**14.** Organische Elektrolumineszenz-Vorrichtung, vorzugsweise OLED-Vorrichtung, hergestellt aus einer Zusammensetzung nach einem oder mehreren der Ansprüche 1 bis 12.

## Revendications

**1.** Composition comprenant un ou plusieurs matériau(x) à émission de lumière organique(s) qui présente(nt) un poids moléculaire d'au plus 5 000 g/mol et un ou plusieurs matériau(x) de transport de charges qui présente(nt) un poids moléculaire d'au plus 5 000 g/mol, un ou plusieurs solvant(s) organique(s), et un ou plusieurs polymère(s), **caractérisée en ce que** lesdits un ou plusieurs polymères comprennent 100 % (pourcentage molaire) d'unités d'ester d'acide acrylique et/ou d'ester d'acide méthacrylique et **en ce que** lesdits un ou plusieurs polymères présentent un poids moléculaire moyen en poids $M_w$ dans la plage qui va de 750 000 à 3 000 000 g/mol.

**2.** Composition selon la revendication 1, **caractérisée en ce que** les unités d'ester d'acide acrylique et/ou d'ester d'acide méthacrylique sont sélectionnées parmi les unités d'ester d'acide acrylique et/ou d'ester d'acide méthacrylique qui comportent un groupe $C_{1-10}$-alkyle, un groupe $C_{3-8}$-cycloalkyle, un groupe $C_{6-14}$-aryle ou un groupe $C_{2-13}$-heteroaryle en tant que groupe ester.

3. Composition selon une ou plusieurs des revendications 1 ou 2, **caractérisée en ce que** ladite composition présente une viscosité à 25°C dans la plage de 1 à 100 mPas.

4. Composition selon une ou plusieurs des revendications 1 à 3, **caractérisée en ce que** ledit polymère présente une température de transition vitreuse dans la plage de -70 à 160°C.

5. Composition selon une ou plusieurs des revendications 1 à 4, **caractérisée en ce que** ladite composition comprend dans la plage de 0,01 à 20 % en poids desdits polymères.

6. Composition selon une ou plusieurs des revendications 1 à 5, **caractérisée en ce que** ledit solvant organique est un solvant organique aromatique.

7. Composition selon la revendication 6, **caractérisée en ce que** ledit solvant organique est sélectionné parmi le groupe qui est constitué par les hydrocarbones aromatiques, les éthers aromatiques, les esters aromatiques, les cétones aromatiques, les solvants hétéro-aromatiques et les dérivés d'aniline.

8. Composition selon une ou plusieurs des revendications 1 à 7, **caractérisée en ce que** ledit solvant organique présente un point d'ébullition ≤ 260°C.

9. Composition selon une ou plusieurs des revendications 1 à 8, **caractérisée en ce que** ladite composition comprend au moins 80 % en poids desdits solvants organiques.

10. Composition selon une ou plusieurs des revendications 1 à 9, **caractérisée en ce que** lesdits un ou plusieurs matériaux à émission de lumière organiques qui présentent un poids moléculaire d'au plus 5 000 g/mol sont un composé phosphorescent organique qui émet de la lumière et qui, en outre, contient au moins un atome qui présente un numéro atomique supérieur à 38.

11. Composition selon la revendication 10, **caractérisée en ce que** ledit composé phosphorescent organique est sélectionné parmi un composé des formules (1) à (4) :

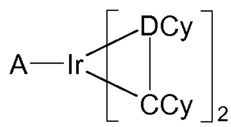
formule (1)

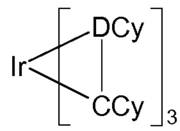
formule (2)

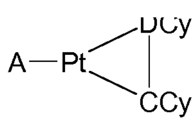
formule (3)

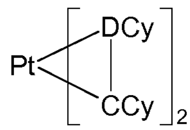
formule (4)

formules dans lesquelles :

DCy est, de manière identique ou différente pour chaque occurrence, un groupe cyclique qui contient au moins un atome de donneur, de préférence un atome d'azote, un atome de carbone sous la forme d'un carbone ou d'un phosphore, atome via lequel le groupe cyclique est lié au métal, et qui peut à son tour être porteur d'un ou de plusieurs substituant(s), $R^1$ ; les groupes DCy et CCy sont connectés l'un à l'autre via une liaison covalente ;
CCy est, de manière identique ou différente pour chaque occurrence, un groupe cyclique qui contient au moins un atome de carbone via lequel le groupe cyclique est lié au métal et qui peut à son tour être porteur d'un ou de plusieurs substituant(s) $R^1$ ;
A est, de manière identique ou différente pour chaque occurrence, un ligand chélatant bidenté monoanionique, de préférence un ligand de dicétonate ;
$R^1$ sont, de manière identique ou différente pour chaque cas, et sont F, Cl, Br, I, $NO_2$, CN, un groupe alkyle ou alcoxy en chaîne droite, ramifié ou cyclique qui comporte de 1 à 20 atome(s) de carbone, où un ou plusieurs groupe(s) $CH_2$ non adjacents peut/peuvent être remplacé(s) par -O-, -S-, -$NR^2$-, -$CONR^2$-, -CO-O-, -C=O-,

-CH=CH- ou -C≡C-, et où un ou plusieurs atome(s) d'hydrogène peut/peuvent être remplacé(s) par F, ou un groupe aryle ou hétéroaryle qui comporte de 4 à 14 atomes de carbone et qui peut être substitué par un ou par plusieurs radical/radicaux non aromatique(s), et une pluralité de substituants $R^1$, soit sur le même le cycle, soit sur les deux cycles, peuvent en association à leur tour former un système de cycle aliphatique ou aromatique monocyclique ou polycyclique ; et

$R^2$ sont, de manière identique ou différente pour chaque cas, et sont un groupe alkyle ou alcoxy en chaîne droite, ramifié ou cyclique qui comporte de 1 à 20 atome(s) de carbone, où un ou plusieurs groupe(s) $CH_2$ non adjacent(s) peut/peuvent être remplacé(s) par -O-, -S-, -CO-O-, -C=O-, -CH=CH- ou -C≡C-, et où un ou plusieurs atome(s) d'hydrogène peut/peuvent être remplacé(s) par F, ou un groupe aryle ou hétéroaryle qui comporte de 4 à 14 atomes de carbone et qui peut être substitué par un ou par plusieurs radical/radicaux $R^1$ non aromatique(s).

**12.** Composition selon une ou plusieurs des revendications 1 à 11, **caractérisée en ce que** ladite composition comprend de 0,25 à 5 % en poids de matériaux à émission de lumière organiques et de matériaux de transport de charges qui présentent un poids moléculaire d'au plus 5 000 g/mol.

**13.** Utilisation d'une composition selon une ou plusieurs des revendications 1 à 12 en tant qu'encre de revêtement ou d'impression pour la préparation de dispositifs électroluminescents (EL) organiques, de préférence des dispositifs OLED.

**14.** Dispositif électroluminescent organique, de préférence un dispositif OLED, préparé à partir d'une composition selon une ou plusieurs des revendications 1 à 12.

Figure 1

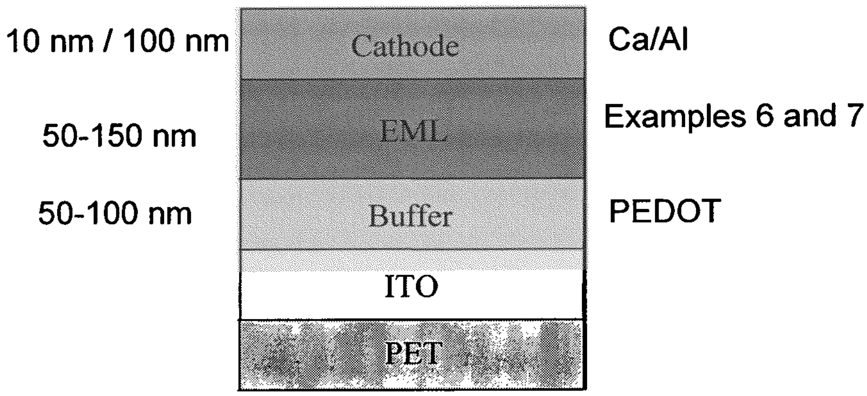


Figure 2

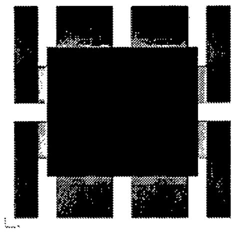

Figure 3

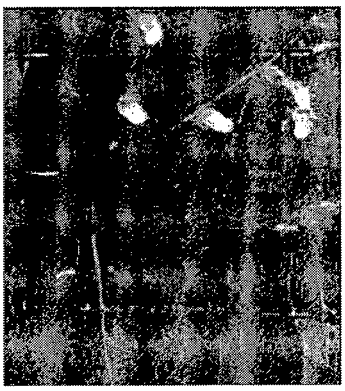

Figure 4

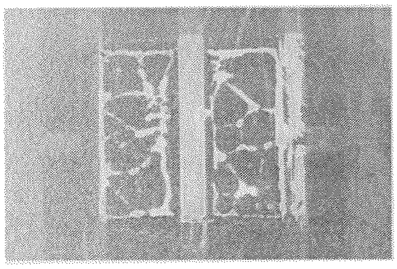

Figure 5

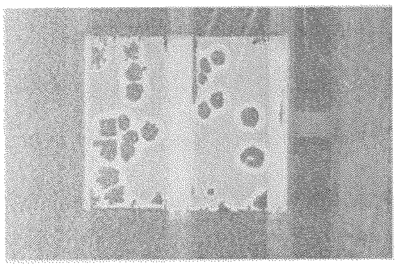

Figure 6

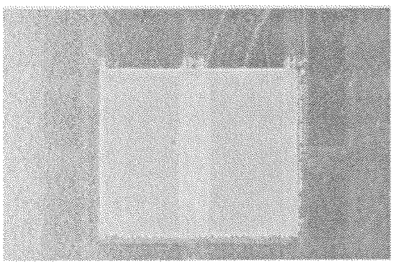

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 1883124 A1
- US 20070103059 A1
- US 6818919 B1
- US 7115430 B1
- US 5952778 B1
- US 6277504 B1
- US 6294273 B1
- WO 2005055248 A2
- US 20120273736 A1
- WO 0070655 A
- WO 0141512 A
- WO 0202714 A
- WO 0215645 A
- EP 1191613 A
- EP 1191612 A
- EP 1191614 A
- WO 04081017 A
- WO 05033244 A
- WO 05042550 A
- WO 05113563 A
- WO 06008069 A
- WO 06061182 A
- WO 06081973 A
- DE 102008027005
- WO 06122630 A
- WO 08006449 A
- WO 07140847 A
- WO 06000388 A
- WO 06058737 A
- WO 06000389 A
- WO 07065549 A
- WO 07115610 A
- DE 102008035413
- JP 6001973 A
- WO 04047499 A
- WO 06098080 A
- WO 07065678 A
- US 20050260442 A
- WO 04092111 A
- EP 676461 A
- WO 04058911 A
- WO 05084081 A
- WO 05084082 A
- WO 06048268 A
- WO 06117052 A
- WO 08145239 A
- WO 04018587 A
- US 5935721 A
- US 20050181232 A
- JP 2000273056 A
- EP 681019 A
- US 20040247937 A
- US 20050211958 A
- EP 1476881 A
- EP 1596445 A
- WO 06100896 A
- EP 1661888 A
- WO 01049806 A
- US 5061569 A
- WO 9509147 A
- JP 2001226331 A
- EP 650955 A
- US 4780536 A
- WO 9830071 A
- EP 891121 A
- JP 2006253445 A
- WO 06073054 A
- JP 2000053957 A
- WO 03060956 A
- WO 04028217 A
- WO 04080975 A
- WO 04013080 A
- WO 04093207 A
- WO 06005627 A
- DE 102008033943
- WO 05039246 A
- US 20050069729 A
- JP 2004288381 A
- EP 1205527 A
- WO 08086851 A
- WO 07063754 A
- WO 08056746 A
- EP 1617710 A
- EP 1617711 A
- EP 1731584 A
- JP 2005347160 A
- WO 07137725 A
- WO 05111172 A
- DE 102008036982
- DE 102007053771
- WO 2004037887 A2

**Non-patent literature cited in the description**


- **Y. SHIROTA et al.** *Chem. Rev.,* 2007, vol. 107 (4), 953-1010
- **HANSON ; ABBOT.** Hansen Solubility Parameters in Practice (HSPiP) program
- **ROGER P. WOODWARD, PH.D.** *Surface Tension Measurements Using the Drop Shape Method*
- **C. M. HANSEN.** Hansen Solubility Parameters: A User's Handbook. Taylor and Francis Group, LLC, 2007
- **M. FISCHER ; F. VÖGTLE.** *Angew. Chem., Int. Ed.,* 1999, vol. 38, 885